Europäisches Patentamt

European Patent Office

Office européen des brevets

(11) Publication number: **0 494 311 A1**

(12)

# EUROPEAN PATENT APPLICATION
## published in accordance with Art. 158(3) EPC

(21) Application number: **91913085.6**

(22) Date of filing: **19.07.91**

(86) International application number:
**PCT/JP91/00971**

(87) International publication number:
**WO 92/01943 (06.02.92 92/04)**

(51) Int. Cl.⁵: **G01R 31/318**, H01L 21/66

(30) Priority: **23.07.90 JP 194241/90**

(43) Date of publication of application:
**15.07.92 Bulletin 92/29**

(84) Designated Contracting States:
**DE FR GB**

(71) Applicant: **SEIKO EPSON CORPORATION**
**4-1, Nishishinjuku 2-chome**
**Shinjuku-ku Tokyo 163(JP)**

(72) Inventor: **OOSHIMA, Yoshimasa**
**3-5, Owa 3-chome**
**Suwa-shi, Nagano-ken 392(JP)**

Inventor: **SHIMIZU, Toshio**
**3-5, Owa 3-chome**
**Suwa-shi, Nagano-ken 392(JP)**
Inventor: **IIDA, Katsuya**
**3-5, Owa 3-chome**
**Suwa-shi, Nagano-ken 392(JP)**
Inventor: **KUMAZAWA, Fumiaki**
**3-5, Owa 3-chome**
**Suwa-shi, Nagano-ken 392(JP)**

(74) Representative: **Blumbach Weser Bergen**
**Kramer Zwirner Hoffmann Patentanwälte**
**Radeckestrasse 43**
**W-8000 München 60(DE)**

(54) **METHOD OF INSPECTING SEMICONDUCTOR DEVICE, APPARATUS FOR INSPECTING THE SAME, AND METHOD OF MANUFACTURING THE SAME.**

(57) In the inspection of a semiconductor device having internal elements including MISFETs, especially complementary MISFETs, whether the semiconductor device is good or defective is judged by static currents flowing through the device in a state that the internal elements are fixed. A stuck-at fault, a fault sensed using conventional fault-simulation of MISFETs, etc., and further a fault relative to the reliability in a long term can be sensed jointly by using a group of patterns which controls the states of the nodes of the internal elements or ON-OFF states of the MISFETs constituting the internal elements as a group of test patterns for the inspection. In the inspection according to the static currents, because of no necessity of considering the observability of faults at an output terminal, the number of the test patterns used for the inspection is small, and the creation thereof is easy too.

EP 0 494 311 A1

FIG. 6

START — ST1

Read out test pattern — ST2

Apply test pattern — ST3

ST4 — IQ measurement ONLY

ST11 — output= expected value

ST12 — test pattern =IQ meaured pattern

ST5 — IQ measurement

ST6 — measured value ≥ specified value

ST7 — test pattern : end

ST8 — NEXT

good

defective

2

Field of the Invention

The present invention relates to a method and a system for inspecting the quality of a semiconductor device which is comprised of circuits containing MISFETs and functional cells. More particularly, the present invention is concerned with those for inspecting the quality of the semiconductor device based on the measurement of static current of the semiconductor device and to a method for producing a semiconductor device whose finished product is inspected by the method of the present invention.

Description of the Related Art

Lately, as semiconductor devices have come to be highly integrated and be given a high functionality, it has become very difficult to carry out a test for determining the quality of the semiconductor devices. For example, while defects on circuits may be relatively easily detected on a printed board in which the circuits are highly integrated since it is possible to carry out the test using endpoints such as individual ICs and resistances in addition to I/O terminals to confirm its function, inside of the semiconductor device like a LSI which is highly integrated is totally a "black box" and the operation of the inside of the LSI can be observed only through external terminals. However, the function still need to be confirmed and determined whether it is good or bad in such LSI since an equipment having a defective LSI will not perform its function in accordance to an intent of its designer. Accordingly, it has become an important issue for not only users but also for circuit designing section and for semiconductor device production section how to accurately inspect a single LSI.

In order to confirm that such semiconductor device is accurately designed and is produced without having productive defects, the designer creates function test patterns using logical simulations. The function test patterns do not always have a high fault detection rate, so the designer has to devise various circuit structures or add test patterns. It is possible to create test patterns that can inspect all combinations of inputs and all internal states to confirm the function of a LSI. However, given a device having n inputs and m internal registers, it needs $2^{n+m}$ of test patterns to inspect the device based on the aforementioned method; it requires an enormous number of test patterns even for a device having 10 inputs and 10 internal registers.

It has been known from experiences that it costs in proportional to square to cube of the number of gates to create test patterns having a high fault detection rate. Furthermore, it is not easy to create test patterns having a high fault detection rate for a high functional and large scale semiconductor device. To this end, several easy-to-test designs in which testing is taken into consideration from the designing stage have been proposed and semiconductor devices are being designed based on those easy-to-test designs.

Problem points in facilitating the tests are roughly divided into two points; a controllability and an observability. The controllability means how gates within the circuit can be driven in the inspection and it is desirable to be able to ON/OFF all the gates in order to detect an abnormality in the circuit. The observability means how to observe the abnormality in the operation of the gates. That is, it means that a fault of the gates cannot be detected as a fault unless it is transmitted to an observation point. In order to accurately carry out the inspection of the semiconductor device, test patterns and circuit design that satisfy both the controllability and the observability are necessary.

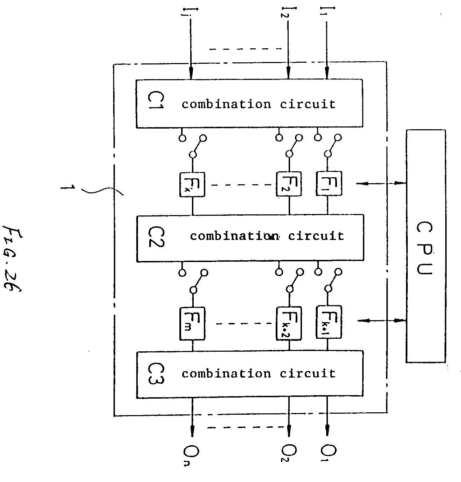

One of methods adopted for highly integrated semiconductor devices among such settings for facilitating the test is a scan-pass method shown in Fig. 26. This method allows to divide circuits structured in a semiconductor device into several combinational circuits C1, C2 and C3 by separating them from the normal connection during the inspection. Those combinational circuits C1, C2 and C3 are then driven and inspected one by one. Although this method requires many flip-flops F1 to Fm for dividing and inspecting the circuits, the controllability and observability of the test patterns may be enhanced since the control points and observation points are increased in response to the added number of flip-flops F1 to Fm in addition to j inputs I1 to Ij and n outputs O1 to On. Furthermore, a test pattern group used for the inspection of the semiconductor device for which such design technique has been adopted is a set of patterns that allow to observe a fault selected from the test pattern group automatically created and selected based on D algorithm and a random number method through fault simulations to enhance the fault detection rate.

To increase the number of observation points, a cross-check method that connects outputs of all gates to terminals for testing has been also proposed. The use of the method allows to improve the fault detection rate, however, it has such a disadvantage that the number of gates and the area of the semiconductor device are increased due to the additional circuits like flip-flops and terminals. Whereas the miniaturization of semiconductor devices is being promoted by highly integrating and giving a high functionality to semiconductor devices, the circuits necessary for inspecting those devices are being increased and the area occupied by the additional circuits is being increased in the device.

There is also another disadvantage that a production cost of the semiconductor device is increased by installing such additional circuits. There is still another disadvantage that operation of the device cannot but be confirmed by an inspection carried out under a state different from a state of the circuit actually used since the inspection is carried out using the additional circuits.

Accordingly, in light of the aforementioned disadvantages, an object of the present invention is to realize a method and a system that allow to inspect a fault on circuits formed on the semiconductor device in a relatively short time and effectively. It is a further object of the present invention to suppress the increase of the area of the semiconductor device due to the additional circuits and to allow to inspect the semiconductor device in real operation.

SUMMARY OF THE INVENTION

According to the present invention, in order to realize the aforementioned inspection, a fault in a semiconductor device is detected by detecting static current that flows in a power circuit of the semiconductor device. The static current is a power source current that flows in a state wherein MISFETs that comprise internal elements of the semiconductor device are fixed to Vdd or Vss. The static current is normally a very weak current that flows in the state when a circuit using MISFETs, especially complementary MISFETs is fixed. Due to that, an excessive leak current that is caused in a production process, a leak current generated accompanying to a short-circuit or an open-circuit and a leak current that causes a lack of reliability in a long range may be measured by measuring the static current. Accordingly, also in the conventional inspection, the static current is used as a supplementary method for functional inspections using the aforementioned test pattern group and only test patterns that assume a certain state are measured.

The present invention notices on that the static current flows even in a degenerate fault or an off-leak fault of the internal elements that comprise the semiconductor device and uses the static current for detecting a fault in functional inspection of the semiconductor device using the test pattern group.

That is, when there is a degenerate fault in which connecting points of the internal elements that compose the circuit are fixed to 0 or 1 or there is an operational failure in the MISFETs themself which comprise the internal elements, the static current may be caused to flow by keeping the state of the internal elements constant. By turning the state of the internal elements into a state in which the static current can flow due to the fault, i.e. into a state in which the fault can be observed by the static current, the static current flows between Vdd and Vss directly or through an intermediary of a very small number of MISFETs in the device having the fault. A detail description will be made later. Accordingly, the fault can be observed very easily by detecting the static current. This inspection method has a very good observability since the fault needs not be observed through terminals connected to the outside through other logical gates. Moreover, this method requires no test pattern in which how to transmit the fault is taken into account to observe the fault to be created as in the conventional inspection method. Therefore, only the controllability of the internal elements needs to be considered in the test pattern group used for the inspection method for detecting the fault by means of the static current. The internal elements are turned into observable state in which the fault can be observed by controlling the internal elements and when there is a fault in the internal elements controlled, the fault can be detected by means of the static current that flows via the fault. The semiconductor device may be a device having single function like a memory chip or a device like a microprocessor in which a plurality of functional cells are built in.

Thus the method for inspecting the semiconductor device of the present invention is a method for inspecting a semiconductor device having at least a functional cell comprising a plurality of internal elements, the method comprising and at least repeating steps of:

controlling states wherein patterns selected in order from a static current inspecting pattern group that controls and turns states of each internal element into observable state in which the static current flows due to a fault are applied to the functional cell;

detecting the static current which is a very weak current that flows in a power circuit of the functional cell after applying the patterns to the cell; and

comparing the static current with a specified value.

This method also allows to carry out the inspection based on the detection of the static current and the conventional method based on output patterns of the semiconductor device or a part of the functional cells in the same time. For such inspection method, an inspection method may be used comprising and at least repeating steps of:

controlling states wherein patterns selected in order from a inspecting pattern group that drives at least

4

one internal element are applied to a functional cell;

determining patterns whether the patterns are ones included in a static current inspecting pattern group that controls and turns states of each internal element into observable state wherein the static current flows due to a fault;

detecting the static current which is a weak current that flows in a power circuit of the functional cell after the patterns included in the static current inspecting pattern are applied; and

comparing the static current with a specific current.

In order to effectively carry out the inspection based on the detection of the static current, it is important to apply patterns that can effectively control and turn the internal elements into observable state to the device. To make the static current inspecting pattern group as an aggregate of such patterns, it is possible to adopt an input value adjusted pattern group in which input values are adjusted so that at least one internal element may be controlled and turned into observable state based on a circuit information of the functional cell of the semiconductor device to be inspected. The patterns contained in the input value adjusted pattern group need not be those in the conventional test patterns which are generated primarily being aimed at propagating a fault to be able to observe the fault occurred in the internal elements at the output, but may be those that can control and turn the internal elements into observable state. Accordingly, the input value adjusted pattern group can be formed in a short time and the use of the pattern group enables to effectively carry out the inspection based on the static current.

As the static current inspecting pattern group, it is also possible to adopt a retrieving pattern group which is formed by extracting patterns suitable for measuring the static current by retrieving states of internal elements controlled by a group of patterns included in the inspecting pattern group from a plurality of inspecting pattern groups manually registered or automatically generated based on the circuit information. Moreover, in order to improve the efficiency of the inspection, it is effective to adopt a first optimized inspecting pattern group extracted in order from patterns that can drive internal elements having less frequency to turn into observable state among patterns included in an inspecting pattern group that can drive at least one internal element. The pattern group optimized by such method is selected from patterns at least necessary and allows to maximize the number of internal elements that turn into observable state. In the same time, it enables to eliminate patterns that control internal elements that turn into observable state by already selected patterns and thereby to improve the efficiency of the inspection.

To make the pattern group that allows to effectively inspect the device, it is also effective to adopt a second optimized inspecting pattern group extracted in order from patterns that contain more numbers of internal elements that turn into observable state among patterns included in an inspecting pattern group that can drive at least one internal element. This pattern group is selected from patterns that are more likely to make observable state and thereby allows to shorten the inspection time.

That the internal elements are in observable state which is a state in which the static current flows due to a fault can be determined from states of nodes (connecting point) that connect internal elements. In an inspection method noticing on the changes of the node state, when there is a degenerate fault in the input or output nodes of the internal elements, a current path can be established between the nodes in which the degenerate fault is caused and Vdd or Vss and an observable state in which the static current flows can be made by setting the node state either to 0 or 1. In such inspection method, a node control pattern group that controls the nodes which are connecting points for connecting the internal elements are used as the static current inspecting pattern group and the observable state is judged by the state of the nodes.

Furthermore, an inspection method noticing on a state of MISFETs that comprise the internal elements is also useful. In the internal elements, results of logical operation by combinations of ON and OFF states of the MISFETs are outputted as signal 0 or 1, but the outputted signals are not inverted or become unstable state and the given functions are not performed if there is a leak (off-leak) in the OFF state of the MISFETs. An off-leak is generated also by such a fault of transistors that does not affect the initial functions like a failure in the gates. Because of that, even when a MISFET having such off-leak is contained, a current path may be established between Vdd and Vss and the static current flows by combining states of other MISFETs. Accordingly, in the inspection method noticing on the off-leak, a transistor control pattern group that controls ON/OFF of the MISFETs that comprise the internal elements may be adopted as a static current inspecting pattern group and the observable state may be judged by a specific state of ON/OFF of the MISFETs that comprise the internal elements. Then the method allows to effectively detect functional faults of the semiconductor device involving off-leaks and faults in the transistors that pose a problem in terms of long range reliability.

When the node control pattern group or the transistor control pattern group is adopted, patterns are included that establish both states in which a path through which the static current flows due to a degenerate fault or due to an off-leak is created in the states of the internal elements, so that the probability to be able to detect other faults in the same time is considerably high. Accordingly, the inspection based on the static current using the pattern groups as described above allows to detect such faults that pose a problem in terms of a long range reliability like failures in transistors like leak current and faulty gates of the semiconductor device caused in the process involving semiconductors simultaneously and effectively in addition to functional faults of the semiconductor device inspected using test pattern groups in the conventional inspection method.

Furthermore, the inspection may be carried out using a control pattern group for which patterns included in either the node control pattern group or the transistor control pattern group are extracted. This inspection allows to detect degenerate faults and off-leak faults. It also allows, of course, to detect the aforementioned failures involving the aforementioned long range reliability.

Such inspection method facilitates to carry out periodic inspections of semiconductor devices in operation and to select defective devices. Then highly reliable semiconductor devices may be produced by adopting this inspection method into an inspection process of the production process of the semiconductor devices. Furthermore, this inspection method requires no terminals and additional circuits for inspection, so that it is best suited for producing high functional and highly integrated semiconductor devices and allows to avoid a labor for connecting extra terminals and troubles caused by that also in periodic inspections and fault diagnoses.

The above inspection may be carried out by a system for inspecting a semiconductor device, the system comprising at least state controlling means for controlling states based on patterns selected in order from a static current inspecting pattern group that controls and turns states of each internal element into observable state in which the static current flows due to a failure and static current comparing means that compares the static current which is a very weak current that flows in a power circuit of the functional cell controlled by a state controlling means with a specified value.

When inspections based on the static current and on the result of the conventional fault simulations are carried out, it is desirable to use an inspecting system at least comprising internal element driving means that drives internal elements based on patterns selected in order from the inspecting pattern group that drives at least one internal element, pattern discriminating means for judging whether the patterns are ones included in the static current inspecting pattern group that controls and turns states of each internal element into observable state in which the static current flows due to a failure and static current comparing means for comparing the static current which is a very weak current that flows in a power circuit of the functional cell with a specified value after the patterns included in the static current inspecting patterns are applied. The static current is a current that flows in the power circuit in a state when the internal elements are stable and are fixed to Vdd or Vss, so that it is desirable to measure the static current after a certain period of time, few $\mu$ to m-seconds for example, passes after the patterns are applied. Accordingly, the inspection may be effectively carried out by measuring the static current when the patterns that turn the internal elements into observable state are applied, not measuring the whole test patterns.

For the static current comparing means, a circuit may be used that is provided with a voltage follower circuit connected to the power circuit of the functional cell and a determining circuit for determining the static current based on a difference of voltage between input and output voltages of an operational amplifier used for the voltage follower circuit. The use of the voltage follower circuit enables to keep the power voltage constant even when a weak current flows, so that it allows to accurately detect the static current without having changes in the amount of current along the fluctuation of the voltage. It is also possible to determine the static current based on the difference of the input and output voltages of the operational amplifier used for the voltage follower circuit. The static current may be determined and the difference of the voltage may be easily amplified without affecting the impedance of the current path by determining the static current by the difference of the voltage of the input and output voltages.

As a static current inspecting pattern group used for these inspection systems, the input value adjusted pattern group, the retrieved pattern group, the first and second optimized pattern groups, the node control pattern group and the transistor control pattern group described above may be used, and the use of those pattern groups enables to effectively carry out the inspection.

The static current inspecting pattern group used for those inspections and inspection systems may be created by a system for creating inspecting patterns at least having input value adjusting means for adjusting input values so that at least one internal element can be controlled and turned into observable state based on the circuit information of the functional cell registered and on the observable state of the internal elements that comprise the functional cell and for creating an input value adjusted pattern group which becomes the static current inspecting pattern group.

In this system for creating patterns, it is enough if input value adjusted patterns that can control and turn states of the internal elements into observable state are created and the patterns need not be ones that mainly aim at propagating faults to the output like those used in the conventional inspection. As a result, the time necessary for creating the static current inspecting pattern can be short. Due to that, the process for creating test patterns which used to take a lot of time in the past can be considerably shortened.

Furthermore, it is also possible to select the static current inspecting pattern group from the inspecting pattern group manually registered or automatically generated. In this case, the static current inspecting pattern group may be created by a system for creating inspecting patterns comprising simulation means for performing logical simulations on each inspecting pattern included in the inspecting pattern group that drives at least one internal element modeling the functional cell and the internal elements registered, element state memorizing means for memorizing the element state of each internal element controlled by the inspecting patterns in the logical simulations, and pattern retrieving means for retrieving patterns that can control and turn the internal elements into observable state in which the static current flows due to a failure from the inspecting pattern group based on the element state and for creating the static current inspecting pattern group. In a semiconductor device having numbers of internal elements and a high degree of integration, it often takes a time to create inspecting patterns that control and turn the internal elements into observable state. In such a case, it is effective to select patterns that control and turn the internal elements into observable state by carrying out logical simulations on the inspecting pattern group manually registered or automatically generated based on the circuit information of the functional cell, by memorizing the element states of the internal elements which are the result of being driven by the inspecting patterns and by retrieving observable states from the element states. Then it becomes possible to create the static current inspecting pattern group by an aggregate of such patterns.

Furthermore, the inspection based on the detection of the static current can be carried so long as the state of the elements become observable and does not require to judge the observability whether faults can be detected at the output of the circuit or the functional cell as in the conventional inspection. Accordingly, the system for creating patterns used for the inspection only needs to have simulation means, element state memorizing means and pattern retrieving means, noticing on the controllability of the state of the internal elements. Thus the system for creating the pattern groups used for the inspection based on the static current may be simplified and the time necessary for creating the pattern group may be shortened.

In the system as described above, the pattern retrieving means may be a first optimized retrieving means for creating the static current inspecting pattern group which extracts in order from patterns that turn the internal elements having less frequency to become observable state into observable state from the inspecting pattern group. In this case, the first optimized retrieving means may be comprised of low-drive internal element retrieving means for retrieving low-drive internal elements which are internal elements having less frequency to become from the element state to the observable state and first optimized pattern extracting means for creating the static current inspecting pattern extracting in order from patterns that turn the low-drive internal elements into observable state from the inspecting pattern group.

The pattern retrieving means may be also second optimized retrieving means for creating the static current inspecting pattern group extracting in order from patterns having more element states controlled and turned into observable state from the inspecting pattern group. In this case, the second optimized retrieving means may be comprised of second optimized pattern extracting means for extracting patterns having more element states controlled and turned into observable state and element state reducing means for erasing the observable states realized by the patterns extracted from the element states to update the element state. The use of the first or the second optimized retrieving means allows to create the static current inspecting pattern group having less overlaps in inspections while controlling and turning many internal element states into observable state. Then, the use of the optimized static current inspecting pattern group allows to carry out accurate and effective inspections in a short time.

Furthermore, the observable state may be judged by states of the nodes as described above, and in this case, it is preferable to use the node control pattern group for controlling the nodes which are connecting points for connecting the internal elements as the static current inspecting pattern group.

Moreover, the observable state may be judged by specific states of ON/OFF of MISFETs that comprise the internal elements. In this case, it is effective if the static current inspecting pattern group is the transistor control pattern group for controlling the ON/OFF of the MISFETs that comprise the internal elements. Moreover, it is possible to judge the observable state by the nodes and by specifying the ON/OFF of the MISFETs, and as the static current inspecting pattern group, a control pattern group comprised of patterns included either in the node control pattern group for controlling the nodes which are connecting points for connecting the internal elements or in the transistor control pattern group for controlling the ON/OFF of the MISFETs that comprise the internal elements may be used.

## BRIEF DESCRIPTION OF THE DRAWINGS

EP 0 494 311 A1

Embodiments of the present invention will now be described with reference to the accompanying drawings, wherein:

Fig. 1 is an explanatory drawing showing an outline of measurement of static current IQ;

Fig. 2 is an explanatory drawing showing a state wherein IQ flows when an output of a NAND gate has a degenerate fault to 1, Fig. 2(a) being a view showing a node state of the NAND gate in such a state and Fig. 2(b) being a view showing a state of transistors that comprise the NAND gate in such a state;

Fig. 3 is an explanatory drawing showing a state wherein IQ flows when the output of the NAND gate has a degenerate fault to 0, Fig. 3(a) being a view showing a node state of the NAND gate in such a state and Fig. 3(b) being a view showing a state of transistors that comprise the NAND gate in such a state;

Fig. 4 is an explanatory drawing showing a state wherein IQ flows when there is an off-leak in the transistors that comprise the NAND gate, Fig. 4(a) being a view showing a node state of the NAND gate in such a state and Fig. 4(b) being a view showing a state of transistors that comprise the NAND gate in such a state;

Fig. 5 is an explanatory drawing showing a state wherein IQ flows when there is an open fault, Fig. 5(a) being a view showing a case when the gate is opened and Fig. 5(b) being a view showing a case when a drain is opened;

Fig. 6 is a flowchart showing a flow of an inspection method using IQ;

Fig. 7 is an explanatory drawing showing an outline of an inspection system used for the inspection shown in Fig. 6;

Fig. 8 is a circuit diagram showing a structure of a static current comparing section used in Fig. 7;

Fig. 9 is a flowchart showing a flow of processes in a prior system for creating test patterns;

Fig. 10 is a flowchart showing a detail flow of processes of a fault simulation shown in Fig. 9;

Fig. 11 is a flowchart showing a flow of processes in a system for creating test patterns used for the inspection based on the measurement of IQ of the present embodiment;

Fig. 12 is an explanatory drawing showing one example of a structure of the system for creating test patterns that can execute the processes shown in Fig. 11;

Fig. 13 is a flowchart showing flows of processes and data in the system for creating test patterns shown in Fig. 12;

Fig. 14 is a flowchart showing a flow of processes for outputting test patterns based on states of nodes;

Fig. 15 is an explanatory drawing showing a part of file output of a node state memory file (IQC);

Fig. 16 is an explanatory drawing showing a part of file output of a frequency file (STF);

Fig. 17 is an explanatory drawing showing a part of file output of a 0-state file (IQL);

Fig. 18 is an explanatory drawing showing a part of file output of a 1-state file (IQH);

Fig. 19 is an explanatory drawing showing a part of file output of a sorted 0-state file (IQLOW);

Fig. 20 is an explanatory drawing showing a part of file output of a sorted 1-state file (IQHIGH);

Fig. 21 is a flowchart showing a flow of detail processes of the pattern selecting step ST73 shown in Fig. 14;

Fig. 22 is a flowchart showing a flow of processes for outputting test patterns based on specific states of primitives shown in Fig. 13;

Fig. 23 is an explanatory drawing showing a part of file output of an internal state information library;

Fig. 24 is an explanatory drawing showing a part of file output of a primitive internal state file (EVST);

Fig. 25 is an explanatory drawing showing a part of file output of a maximum event file (MEV); and

Fig. 26 is an explanatory drawing showing an outline of a scan-pass method which is one example of the conventional inspection methods.

## DETAILED DESCRIPTION OF PREFERRED EMBODIMENT

[About Static Current]

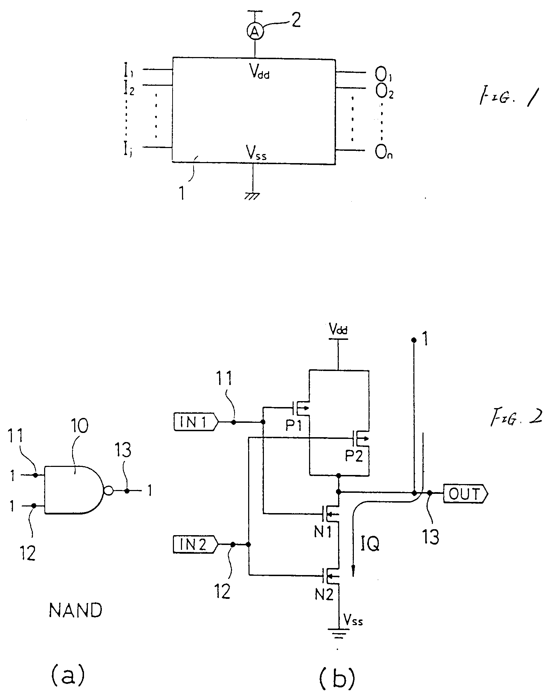

At first, the static current used for determining the quality of a semiconductor device in the present invention will be explained. As shown in Fig. 1, IQ (static current) is a current that flows between Vdd and Vss of a power circuit of an IC (semiconductor integrated circuit device) 1. In order to avoid an effect of a drive current caused in a state wherein gates within the IC 1 are driven, IQ is measured after a certain period of time has passed since test patterns have been inputted from input terminals I1 to Ij in a state wherein the gates are fixed. An ampere meter 2 for measuring IQ may be installed also at the side of Vss, not the side of Vdd as shown in Fig. 1, and it is possible to detect IQ using also a comparing means like a comparator, not necessarily by an ampere meter, so long as it is for determining the quality. By the way, this IQ may be measured not only between power circuits of the whole IC, but also for each specific cell structured in the IC, e.g. each functional cell having an independent power circuit in memory cell, logical cell and the like.

Although various faults may be detected by measuring IQ, the relationship of a degenerate fault and an off-leak of MISFET with IQ is outlined below.

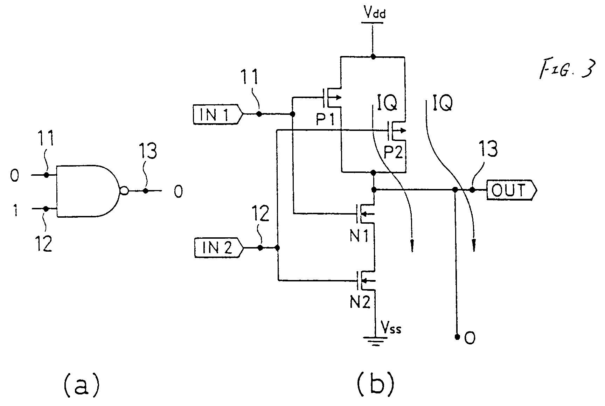

Figs. 2 and 3 show cases when a degenerate fault is caused at an output terminal of a two-input NAND. Fig. 2 shows a degenerate fault by which an output terminal 13 is fixed to 1. In this case, whereas both transistors N1 and N2 become ON in the input, IQ flows from the output terminal 13 to Vss. That is, IQ flows by a test pattern that turns both input terminals 11 and 12 to 1 and the output terminal 13 to 0. Accordingly, in the degenerate fault by which the output terminal 13 is fixed to 1, a state wherein the output terminal 13 becomes 0 is an observable state, and the internal element NAND has to be controlled so that the output terminal 13 becomes 0 to determine whether the degenerate fault exists or not.

IQ has to be measured in a state in which internal elements like the NAND 10 are fixed in order to avoid the effect of current in drive state. The state in which a certain test pattern is thus applied to an IC and the internal element is fixed is referred to as an "event" for the test pattern hereinafter.

In the case when the output terminal 13 is fixed to 0 as shown in Fig. 3, contrary to the degenerate fault aforementioned, IQ flows from Vdd in an event in which either transistor P1 or P2 becomes ON. That is, the degenerate fault by which the output terminal 13 is fixed to 0 may be detected by measuring IQ in the event in which either input terminals 11 or 12 is 0 and the output terminal 13 is 1. The states of the input terminals 11 and 12 and the output terminal 13 which are the nodes of the NAND 10 turn out as shown in the following table.

TABLE 1

| Node | | | Possible to Detect | Possible to Detect |
|------|------|------|--------------------|--------------------|
| 11 | 12 | 13 | Degeneration to 1 | Degeneration to 0 |
| 0 | 0 | 1 | X | O |
| 1 | 0 | 1 | X | O |
| 0 | 1 | 1 | X | O |
| 1 | 1 | 0 | O | X |

Thus the states in which the node 13 is 0 and 1 are the state in which the degenerate fault is observable in the inspection noticing on IQ. Then, in order to detect the degenerate fault, test patterns that control the node 13 to 0 and 1 need to be applied to the IC.

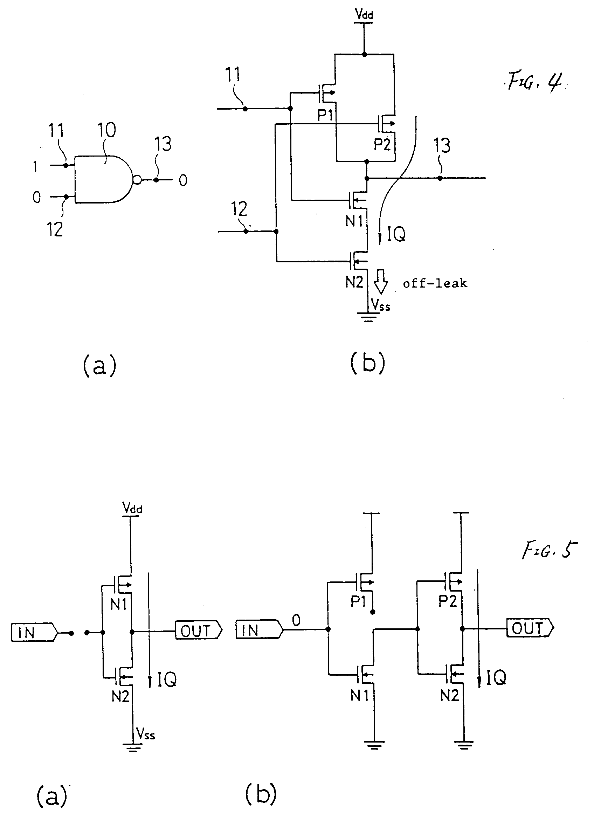

Fig. 4 shows a case when there is an off-leak in the transistor N2 in the NAND 10. When there is the off-leak in the transistor N2, IQ flows from Vdd to Vss when the transistors P2 and N1 become ON. That is, the off-leak of the transistor N2 may be detected by measuring IQ in an event in which the node 11 is 1 and the node 12 is 0. Accordingly, the state wherein the node 11 is 1 and the node 12 is 0 is the observable state for the transistor N2, and in order to detect the off-leak, test patterns that can control the node 11 to 1 and the node 12 to 0 need to be applied.

In the same manner, to detect an off-leak in the transistor N1, IQ is measured when the transistors P1 and N2 are ON, i.e. in an event in which the node 11 is 0 and the node 12 is 1. To detect an off-leak in the transistor P1 or P2, IQ is measured when the transistors N1 and N2 are ON, i.e. in an event in which the nodes 11 and 12 are 1. The foregoing events may be summarized as in Table 2.

TABLE 2

| Node | | | Possible to Detect Off-leak | | | | Specific State of Element |
|---|---|---|---|---|---|---|---|
| 11 | 12 | 13 | P1 | P2 | N1 | N2 | |
| 1 | 1 | 0 | O | O | X | X | A |
| 1 | 0 | 1 | X | X | X | O | B |
| 0 | 1 | 1 | X | X | O | X | C |
| 0 | 0 | 1 | X | X | X | X | - |

As seen from Table 2, observable states for detecting IQ connected to the off-leak of the transistors are specific states A, B and C which are determined by the nodes 11, 12 and 13 and the transistor structure of the NAND, the internal element, in addition to the states wherein the node 13 is 0 and 1. Accordingly, to confirm the off-leak in all the transistors that comprise the NAND, an internal element, a plurality of test patterns that control and turn the NAND into the specific states A, B and C need to be applied to the IC.

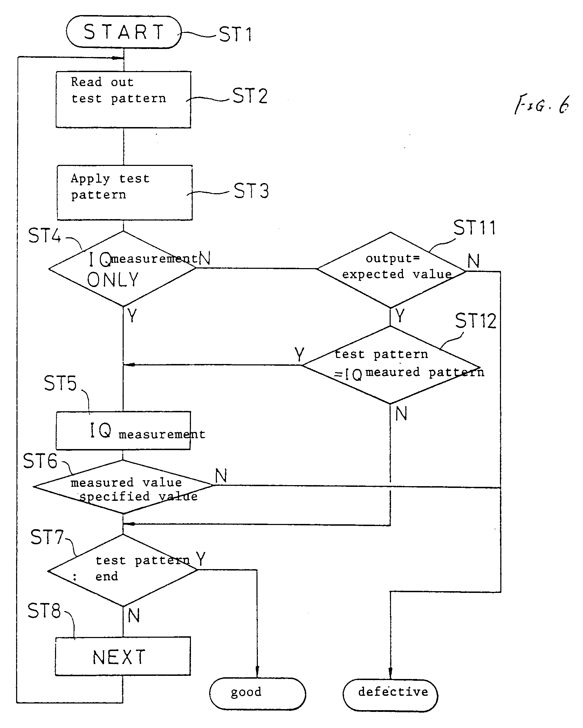

Thus the failure may be detected by measuring IQ in an event in which the state of the internal elements is controlled and turned into observable state, i.e., in the state in which the node is 0 and 1 in a degenerate fault and in an event in which the state of the internal elements is controlled and turned into a specific state in the off-leak of the transistors. Beside that, there are several failures by which IQ flows. For example, where there is an open fault in any of gate, drain or source, a gate potential of a transistor connected to the transistor, the drain or the source becomes unstable as shown in Fig. 5. In such transistor, the gate potential is often at the intermediate potential, a switching point. Accordingly, both a n-channel transistor and a p-channel transistor of the gate become transient state and transient current successively flows. Because of that, their fault may be also detected by measuring the transient current as IQ.

[Inspection Method and Inspection System Using Static Current]

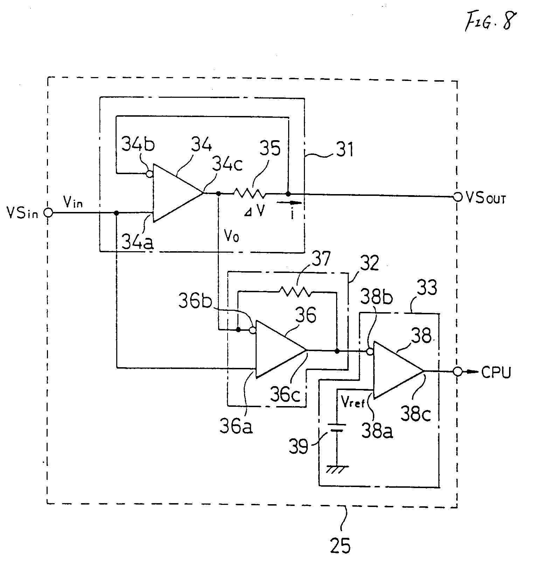

Figs. 6 and 8 show one example of the inspection method and the inspection system using IQ (static current). The inspection method and the system of the present example are adapted to be able to detect the quality of a semiconductor device from output waveforms based on test patterns selected by a result of the conventional fault simulations as an option, in addition to the IQ measurement.

The inspection for detecting the quality of an IC (semiconductor device) by measuring IQ is carried out in accordance with a flow chart shown in Fig.6. Each step thereof is explained below.

Step ST1: The inspection is started after setting an I/O unit, a power unit and an IQ measuring unit to input/outputs and power circuits of the IC to be inspected.

Step ST2: Test patterns registered are called out. The test patterns are those selected in order from a test pattern group for measuring IQ created by a pattern creating unit described later. It is also possible to add a test pattern group selected by means of the fault simulations to the test pattern group for measuring IQ. It is also possible to create a test pattern group from circuit information of the IC in this step.

Step ST3: Patterns are generated by a pattern generating unit based on the test patterns selected or called out in Step ST2 to apply to each input terminal I of the IC.

Step ST4: The inspection to be executed is determined whether it is one only for measuring IQ or for detecting the quality also comparing with the fault simulations provided as an option. The step moves to Step ST 11 when the comparison with the fault simulations is also perfomred.

Step ST5: IQ which is a very weak current that flows in a current circuit is measured after the circuits within the IC become stable by the test patterns applied in Step ST3.

Step ST6: If the measured value of IQ measured in Step ST5 is less than a specified value, it is determined that there is no fault in the internal elements and on the circuit to be detected by the test patterns applied in Step ST3 and the step proceeds to Step ST7. On the other hand, if the measured value of IQ is not less than the specified value, the semiconductor device is determined to be defective since there exists a path where IQ flows due to some fault.

Step ST7: It is determined whether test patterns of the test pattern groups prepared for applying to the IC to measure IQ are left without having been applied. If the measurement of IQ has been finshed using all the prepared test pattern groups, the IC is determined to be good since IQ was less than the specified value in all the test pattern groups prepared and there is no fault detectable by the test pattern groups.

Then the IC is subjected to other inspection. If patterns of the test pattern group prepared have not been finished, the step proceeds to Step ST8.

Step ST8: The measured value of IQ in the test pattern is cleared and the step returns to Step ST2 to measure IQ in the next test pattern. The aforementioned steps are repeated until all the patterns of the test pattern group prepared finish.

Step ST11: When the comparison with the fault simulations prepared as an option is made, an output pattern that corresponds to the test patterns applied to the input terminal of the IC in Step ST3 is compared with an expected value outputted in the fault simulations. If it agrees with the expected value, no fault has propagated to the output pattern and the step proceeds to Step ST12. When it does not agree with the expected value, the output pattern has been changed due to a fault and the IC is determined to be defective. The expected value compared in this step needs not be an expected value in the fault simulation as in this example. It is possible to apply the same test pattern to a IC already determined to be good to compare with the result thereof.

Step ST12: It is determined whether the test pattern applied to compare with the result of the fault simulation is one of the test pattern group registered for inspecting IQ. If the test pattern applied is one of the test pattern group registered for inspecting IQ, the step moves to Step ST5 and the quality is determined based on the measurement of IQ and the measured result thereof.

Even if same test patterns are applied to the IC, some pattern does not propagate a fault to an output pattern. However, if it is in observable state in which the fault can be observed by IQ, the fault can be detected by measuring IQ regardless of the output pattern. Accordingly, for the IC not determined to be defective in Step ST11, IQ is measured in Step ST5. The number of patterns included in the test pattern group used for measuring IQ can be also less than the number of patterns included in the test pattern group provided for comparing with the fault simulation because the observability needs not be taken into consideration. Due to that, IQ needs not be measured for the whole test pattern group provided for comparing with the fault simulations. Accordingly, when the test patterns applied are not included in the test pattern group used for measuring IQ, the step moves to Step ST7 without measuring IQ to carry out the inspection by the next test pattern.

Thus process or design faults of circuits of the semiconductor device which used to be detected by comparing with the result of the fault simulations in the past can be detected by the inspection measuring IQ. The IQ related to those failures can be measured if the state of internal elements that comprise the circuit becomes observable state in which the IQ flows due to the failures, so that the test pattern group in which observability in the output pattern is taken into consideration needs not be used, differing from the past method. Accordingly, it becomes possible to considerably reduce the number of patterns included in the test pattern group which used to increase due to the requirement of the observability in the conventional inspection method. Furthermore, the relationship between internal elements needs not be considered because it is enough if the state of each internal element can be controlled and turned into the observable state. That is, even if a plural number of internal elements turn into observable state in the same time, it is possible to detect a fault if it exists by measuring IQ. Therefore, the number of the test patterns used for the inspection can be reduced further by controlling and turning the plurality of the internal elements into the observable state. Accordingly, it is possible to considerably reduce the time necessary for inspecting the IC and to inspect even semiconductor devices having high integration density and a high functionality accurately and in a short time.

Furthermore, the observability at the output terminal needs not be taken into consideration in the semiconductor device whose fault is to be detected by measuring IQ. Due to that, such methods as the scan-pass method which aims at adding output terminals to improve the observability and to prevent the increase of test patterns in the past need not be adopted. Accordingly, in a semiconductor device produced by a production method adopting this inspection process, no additional circuit for inspection is necessary and the same reliability with the semiconductor device using the scan-pass method and others may be maintained without having the additional circuits. Therefore, even in a highly integrated semiconductor device, the reliability can be improved while preventing the increase of the area due to the additional circuits.

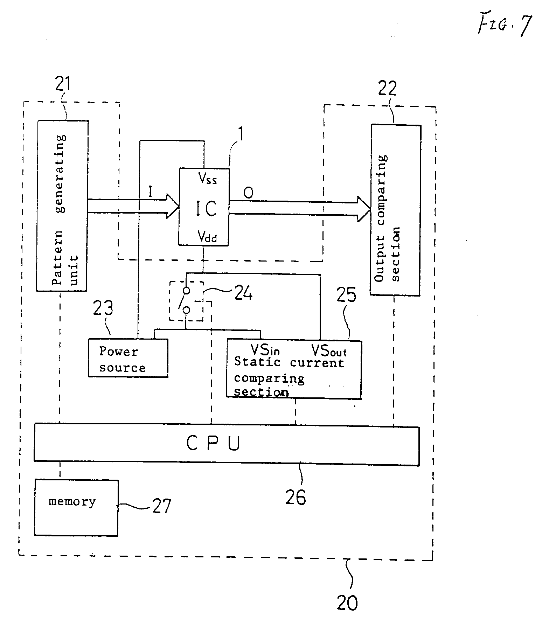

Fig. 7 shows one example of a system used for the aforementioned inspection. An inspection system 20 is comprised of a CPU 26 for controlling functions such as the selection of test patterns from a test pattern group stored in a memory 27, a pattern generating unit 21 for generating patterns based on the test patterns selected and for applying them to the IC 1, a power source unit 23 for supplying power to the IC 1; a power source switch 24 that switches a power source supply line to measure IQ after the internal elements are fixed by the patterns applied, a static current comparing section 25 that measures IQ in a state wherein the internal elements are stabilized and compares with a specified value, an output comparing section 22 that optionally compares results of fault simulations and output patterns of the IC, and the memory 27 in which the test pattern group created for measuring IQ are stored. In the memory 27, when the comparison with the fault simulations is required optionally, a test pattern group used for the fault simulations and an output pattern group which is the expected value of the test pattern group are stored together.

This inspection system 20 allows to carry out the inspection for detecting the quality of the IC 1 based on the measurement of IQ as described above. At first, patterns are selected in order from the test pattern group stored in the memory 27 by the CPU 26 and the selected patterns are applied to the IC 1 by the pattern generating unit 21. At this time, the power unit 23 is directly connected to a power circuit Vdd and Vss of the IC 1 to supply power necessary for the internal elements driven by the applied patterns. After a certain period of time since the state of the internal elements is stabilized, the switch 24 is opened by the direction of the CPU 26. Then the power unit 23 is connected to the IC 1 through the intermediary of the static current comparing section 25 and the value of IQ and the specified value are compared in the state wherein the internal elements are stable.

If the value of IQ measured is less than the specified value, the next test pattern is selected from the test pattern group stored in the memory 27 by the CPU 26 and is applied to the IC 1 by the pattern generating unit 21. At this time, the switch 24 is returned to a state wherein power is directly supplied to the IC 1 from the power unit 23 by the direction of the CPU 26. On the other hand, if the value of IQ measured is not less than the specified value, the IC 1 is determined to be defective by the CPU 26. The system indicates that the IC 1 is defective and finishes the inspection.

When the comparison with the fault simulation provided as an option is made, a pattern is selected from the test pattern group used for the fault simulations and stored in the memory 27 by the CPU 26 and is applied to the IC 1 through the intermediary of the pattern generating unit 21. Then an output pattern of the IC 1 is detected by the output comparing section 22 and is compared with the expected value supplied from the memory 27 through the intermediary of the CPU 26. If the output pattern obtained does not agree with the expected value, the CPU 26 determines that the IC 1 is defective and finishes the inspection indicating the result. When the output pattern obtained agrees with the expected value, the CPU 26 judges whether the test pattern is one included in the test pattern group for measuring IQ. When IQ is measured, the switch 24 is opened and IQ measured is compared by the static current comparing section 25.

By the way, an inspection system in which the comparison with the fault simulation, which is an option, is not made can do without the output comparing section 22. The memory 27 also may be one having a small memory capacity since the test pattern group used for the simulation and the output pattern group which is the expected value thereof need not be stored. Accordingly, the inspection system 20 can be put into compact size, so that it is suited as an inspection system used for periodic inspection and fault diagnosis of ICs in operation. Moreover, when the capacity of the memory 27 is large, it is possible to store test pattern groups of various ICs or to create test pattern groups by carrying out simulations for every circuit to be inspected. Such inspection system may be used as an inspection system in production process of semiconductors.

Although it is possible to structure the static current comparing section 25 of the inspection system using various appratuses such as an ampere meter and a current comparator, IQ is converted to voltage and is amplified to compare with a reference voltage to determine as a measured value of IQ in the system of this example, as shown in Fig. 8.

Fig. 8 shows the main components of the static current comparing section 25. The static current comparing section 25 is comprised of a voltage follower circuit 31 that can keep a voltage of an output terminal VSout even if current flows from an input terminal VSin to the output terminal VSout, an amplifying circuit 32 that amplifies the difference of voltage in the voltage follower circuit 31, $\Delta V$, and a comparing circuit 33 that compares the amplified voltage V1 with the reference value.

In the voltage follower circuit 31 of this example, a voltage follower by means of an operational amplifier 34 is adopted. That is, a non-inverting input 34a of the operational amplifier 34 is connected to the input terminal VSin and an output 34c of the operational amplifier 34 is connected to the output terminal VSout through an intermediary of a resistor 35. Then, the output terminal VSout side of the resistor 35 is connected to an inverting input 34b of the operational amplifier 34 to form the voltage follower. When a very weak current i flows from VSin to VSout in such circuit, a voltage drop $\Delta V$ is caused due to the resistor 35. As a result, the following expression is derived;

$$Vin - (V1 - \Delta V) = V0/\mu \qquad (1)$$

where Vin is a voltage at the non-inverting input 34a of the operational amplifier 34 and V0 is a voltage at the output 34c. When μ which is an amplification factor of the operational amplifier 34 is very large, the right side of the expression (1) becomes 0, so that the voltage V0 at the output 34c is;

$$V0 = Vin + \Delta V \qquad (2)$$

Accordingly, the very weak current i that flew between the terminals VSin and VSout can be detected by measuring the difference of the voltage between the non-inverting input 34a and the output 34c of the operational amplifier 34. Moreover, since the voltage follower is used, the voltage of the VSout can be kept constant even if the current i flows. Accordingly, the static current can be detected eliminating an error of current accompanying to fluctuation of the voltage.

The amplifying circuit 32 is connected in parallel with another operational amplifier 36 between the operational amplifer and an inverting input 36b and an output 36c of the operational amplifer 36. Therefore, the difference $\Delta V$ of the voltage Vin inputted to a non-inverting input 36a of the operational amplifier 36 and the voltage V0 inputted to the inverting input 36b is amplified to emerge as voltage V1 at the output 36c. This outputted voltage V1 is compared and determined by the comparing circuit 33.

In the comparing and determing circuit 33 of this example, the voltage V1 inputted to an inverting input 38b and a reference voltage Vref of a battery 39 inputted to a non-inverting input 38a are compared using a comparator 38. Because of that, when the voltage V1 is higher than the reference voltage Vref, i.e. when the static current IQ is higher than the specified value, a high level signal is outputted from the comparing and discriminating circuit 33.

Although one example of the system for which test patterns are applied and IQ is measured from outside of the semiconductor device has been shown here, it is also possible to realize the pattern generating unit and the static current comparing circuit within the semiconductor device to make a semiconductor device that can diagnose itself.

Furthermore, it is also possible to facilitate the inspection by adding scan flip-flops and the like to the semiconductor device and measuring IQ in order to improve the controllability of turning the internal elements into observable state.

[System for Creating Test Patterns Used for the Inspection Based on the Static Current]

In the inspection in which the quality of a semiconductor device is determined based on the detection of IQ as described above, the creation of the test patterns applied to the semiconductor device is important to carry out the inspection effectively and in a short time, having a high fault detection rate.

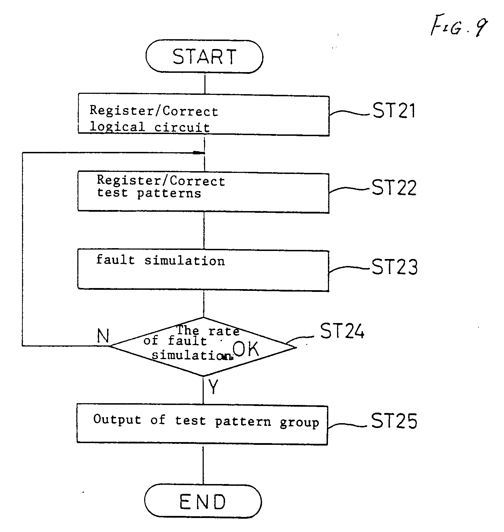

Test patterns used in the conventional inspection are selected based on fault simulations. Fig. 9 shows one example of a flow of processes in a system for creating test patterns used in the conventional inspection. At first, a logical circuit of a semiconductor device to be inspected is registered (ST21). Based on the information of the logical circuit, a test pattern group is registered (ST22). In a semiconductor device having less gates that comprise the circuit, they are manually registered, but in ones having numbers of gates, generally they are automatically produced by a random number method, D algorithm and the like and are verified by the fault simulations that follow (ST23). As a result of the fault simulations, if the number of faults detected by the registered test pattern group is small, that is, the patterns included in the test pattern group has a low fault detection rate, test patterns are added and changed to carry out the fault simulations again (ST24). When the detection rate cannot be improved even if the test patterns are added and changed, sometimes the circuit design itself is reviewed. Then if a certain fault detection rate is achieved, its test pattern group is outputted (ST25).

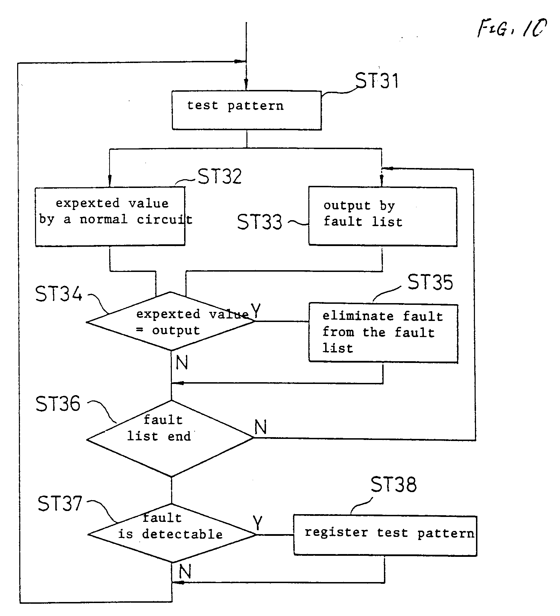

In the conventional inspection method, it has been important to verify whether a fault is observable even in the fault simulations since a test pattern group that satisfies both a controllability for inducing the fault and an observability for observing the fault has to be created. Fig. 10 shows one example of the fault simulation. At first, one pattern is selected from the test pattern group produced automatically or manually (ST31). Then a simulation is carried out by a normal circuit to find an expected value (ST32). On the other hand, each presumed fault in the registered logical circuit is listed up in a fault list and a simulation is carried out in a circuit which reflects the fault according to the list to find the output (ST33).

The expected value found in the ST32 and the output found in the ST33 that reflects the fault are compared (ST34). When the expected value and the output do not agree, an object fault can be observed by applying the test pattern. Therefore, that fault is eliminated from the fault list (ST35). Thus the drop of the efficiency due to the double inspection is prevented. It is determined whether simulations have been carried out for each fault listed in the fault list and if there still exist faults in the fault list, the step returns to ST33 to repeat the above flow (ST36).

If the simulations have been finished for faults listed in the fault list, it is determined if a fault is detected by the test pattern (ST37). The test pattern by which the fault was detected is registered to be outputted (ST38). The above flow is repeated for every each test pattern to extract a test pattern that can detect the fault. As described before, in the conventional inspection method, the test pattern group is formed judging whether each fault is transmitted to the output to satisfy the observability using the fault simulations. Generally there are not so many faults observed by one test pattern and the fault detection rate cannot be improved unless a test pattern group containing a very large number of test patterns is used. Moreover, when a plurality of faults occur in the same time, the time necessary for the fault simulations increase and it takes very long time to form the test pattern group if the plurality of the faults are to be determined if they are observable.

Contrary to that, IQ adopted as a means for detecting faults according to the present invention enables to detect the fault if a state of internal elements that compose a circuit is turned into observable state in which IQ flows due to the fault, as described above. Due to that, the observability at the output needs not be taken into consideration and the fault simulations need not be carried out like the system that creates the test pattern group used for the conventional inspection.

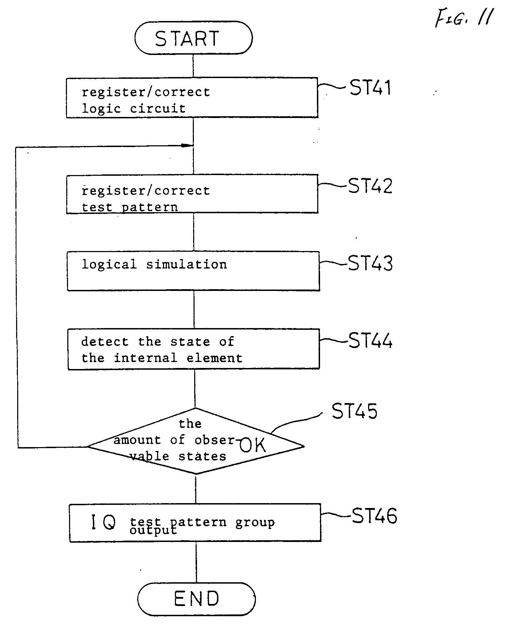

Fig. 11 shows an outline of the operation of a test pattern creating system for creating a test pattern group used for the inspection based on the measurement of IQ according to the present embodiment. The content of each step is explained below:

Step ST41: Detail of a logical circuit of a semiconductor device to be inspected is registered. In this example, an interactive large scale circuit accommodated logical simulator is used as described later.

Step ST42: A test pattern group is registered based on the information of the logical circuit. Though the test pattern group may be registered manually in the semiconductor device having less gates that structure the circuit, generally they are automatically generated by a random number method, D algorithm and the like in those having numbers of gates.

Step ST43: In order to memorize the internal state of the semiconductor device to which the registered test pattern group has been applied, logical simulations are carried out for every each test pattern.

Step ST44: States of element of the internal elements obtained from the logical simulations are retrieved and test patterns that can control and turn the elements into observable state are selected to form an IQ test pattern group.

Step ST45: Whether the amount of the observable states controlled by the IQ test pattern group created in Step ST44 is enough for judging the quality of the semiconductor device is determined. If the observable states of the internal elements are not enough, the step returns to Step ST42 to modify and add the test patterns.

Step ST46: When enough IQ test pattern group is obtained to detect a fault, the test pattern group is outputted.

Thus, in the test pattern group used for the inspection based on IQ or in the system for creating the IQ test pattern group, the observability at the output needs not be confirmed and the expected value for the test pattern group needs not be outputted. Accordingly, the time necessary for outputting the test pattern group can be shortened since only the state of the internal elements needs to be noticed to select test patterns to create a test pattern group. Moreover, even if a plurality of faults occur in the same time, the fault detection rate by one test pattern is high since IQ flows corresponding to each fault and allows to detect the faults. Then, the number of test patterns registered beforehand and the number of patterns selected as the IQ test pattern group may be less than the number of test patterns necessary for the conventional inspection, so that the time necessary for the simulations can be shortened.

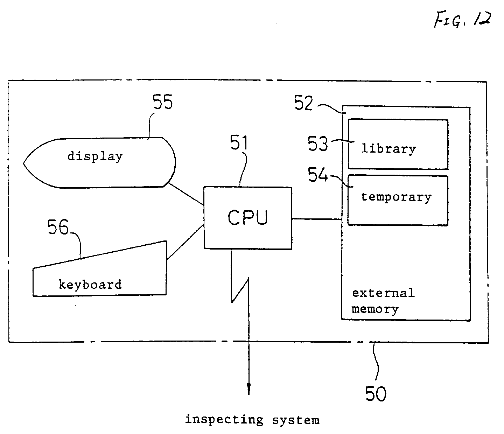

Fig. 12 shows a structure of the system for creating test patterns of the present embodiment. The present system 50 is comprised of a CPU 51 that controls an external memory 52 and performs simulations and others, a library domain 53 in which graphic information of the logical circuit, the structure of internal elements, delay information and the like are registered, the external memory 52 that contains a temporary domain 54 in which output in each step is stored and a display 55 and a keyboard 56 connected to the CPU 51. The test pattern creating system 50 is connected to an outside semiconductor inspection system to be able to output IQ test pattern group created to an inspecting system.

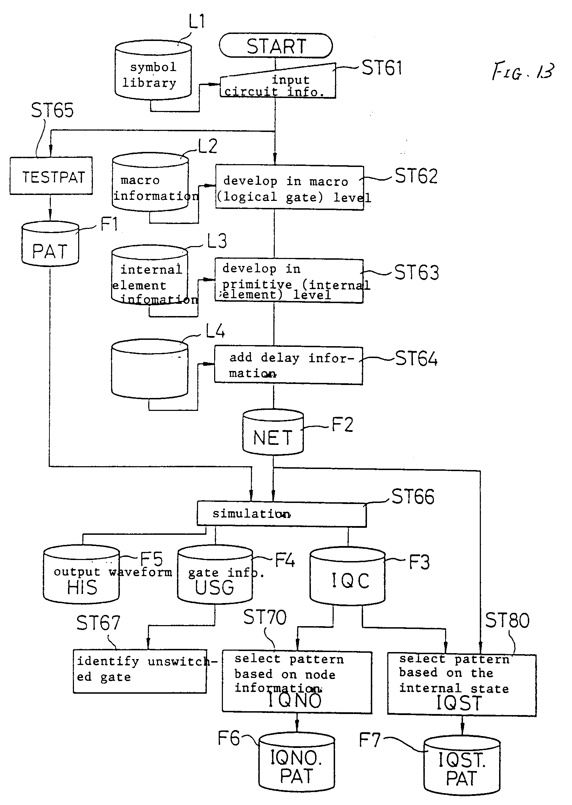

Fig. 13 shows a flow of processes for creating the IQ test pattern group in this test pattern creating system 50. A part of the logical circuit simulator is used for the creating system in this example. The content of each step is explained below:

Step ST61: Symbols provided with necessary functions are selected from a symbol library L1 which is an interactive circuit information registering system and which is registered in a library of the external memory 52 to register on a screen. In the system of this example, a technique for hierarchically designing the logical circuit is adopted and the logical circuit can be registered by connecting buses,

14

shift registers or user-defined logical symbols and the like.

Step ST62: The symbols that structure the logical circuit registered in Step ST61 are developed in a soft-macro of a macro information library L2 registered. In this stage, the logical symbols are developed based on logical gates like flip-flop, NAND and the like.

Step ST63: The logical circuit developed in the soft-macro by Step ST62 is developed in a hard-macro actually arranged in the semiconductor device based on an internal element information library L3. The hard-macro are limited elements like NAND, NOR, inverter and the like and simulations are carried out in unit of those elements. The state of those elements are limited and the simulation can be executed without developing into a transistor level that structures each element.

Step ST64: Delay of internal elements and delay between each element are taken in from a delay information library L4, a model used for the simulation is prepared and it is outputted to a delay file (NET) F2 created in the temporary domain 54 of the memory.

Step ST65: On the other hand, the test pattern used for the simulation is manually registered or automatically generated based on the logical circuit information registered in Step ST61 and outputted to a pattern file (PAT) F1 created on the temporary domain 54.

Step ST66: The test pattern outputted to the pattern file F1 is applied to the simulation model outputted to the delay file F2 to carry out the logical simulation. Then, states of all nodes in each event applied to the test pattern is outputted to a node state memory file (IQC) F3 of the temporary domain 54. In the same time, states of each developed logical gate being driven by the test pattern are outputted to a gate information file (USG) F4 of the temporary domain 54 and an output waveform of the model in each test pattern is outputted to an output waveform file (HIS) F5.

Step ST67: When there is a logical gate not being driven by the test pattern in the pattern file F1 based on the gate information file F4, a test pattern is added and changed.

Step ST70: The node state memory file F3 is retrieved as described later to select a test pattern that allows to efficiently measure IQ and to output it to a node control pattern file F6 of the temporary domain 54.

Step ST80: A file for retrieving a specific state of the internal elements is prepared as described later from the node state memory file F3 and the delay file F2. Then a test pattern is selected by retrieving the file based on the specific state of the internal elements and is outputted to a transistor control pattern file F7 of the temporary domain 54.

[System for Creating Test Patterns based on Node State]

Another test pattern creating system that retrieves a test pattern that creates a state in which IQ is measured noticing on state of nodes, i.e. 0 or 1 of the node of internal elements that compose a semiconductor device and that outputs is explained below. The inspection carried out by the test pattern outputted in this system is an inspection noticing on degenerate fault of a semiconductor device as described before.

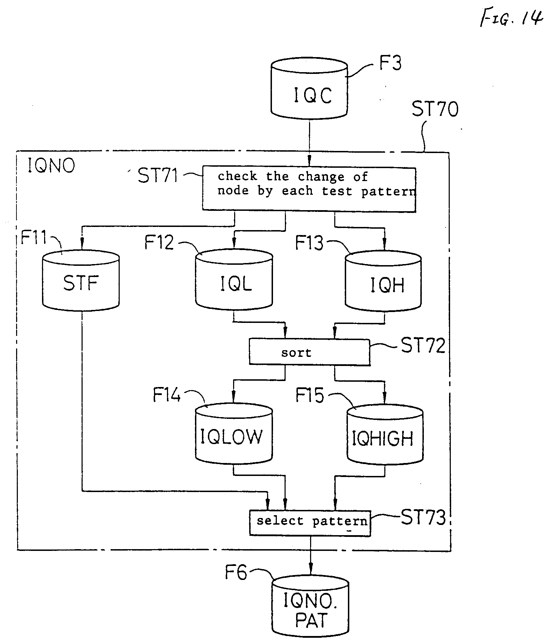

Fig. 14 shows a flow of processes of this system. Each step is explained below.

Step ST71: The node state memory file F3 which is an output of simulations is retrieved to extract the number of nodes whose state is changed in every each event, events which become 0 by every each node and events which become 1. The cases when the state of the node becomes 0 and 1 is the observable state wherein the degenerate fault can be detected. Accordingly, processing is carried out noticing on the state of the node which is 0 or 1.

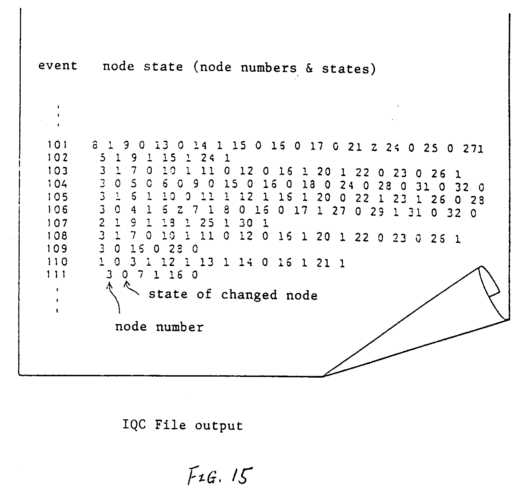

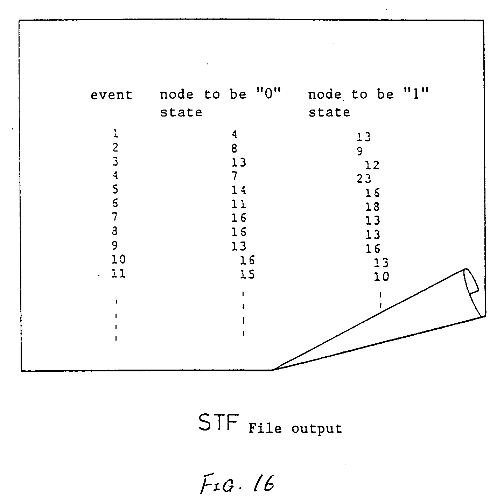

In the node state memory file F3, No. of node whose state is changed in each event and the state changed are outputted as a part of the file output is shown in Fig. 15. From the state of those nodes, the number of nodes whose state becomes 0 and the number of those whose state becomes 1 in every event are outputted to a frequency file (STF) F11. A part of the file output of the frequency F11 is shown in Fig. 16.

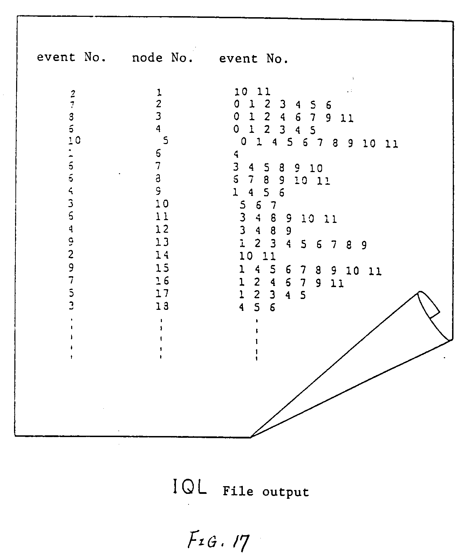

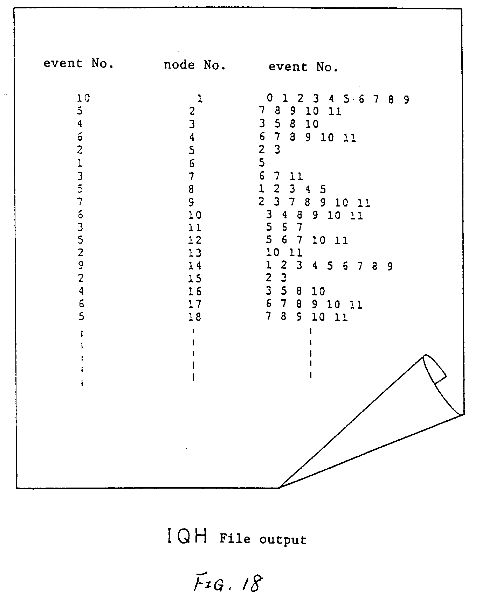

Then, events in which the state of each node becomes 0 are retrieved from the node state memory file F3 and event Nos. and the number of events are outputted to a 0-state file (IQL) F12 for every each node. In the same manner, events in which the state of each node becomes 1 are retrieved and event Nos. and the number of events are outputted to a 1-state file (IQH) F13 for every each node. A part of the file outputs of the 0-state file F12 and the 1-state file F13 are shown in Figs. 17 and 18.

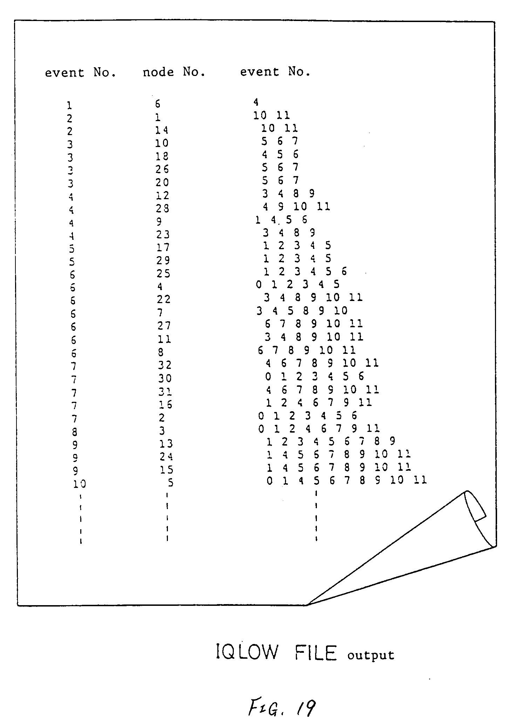

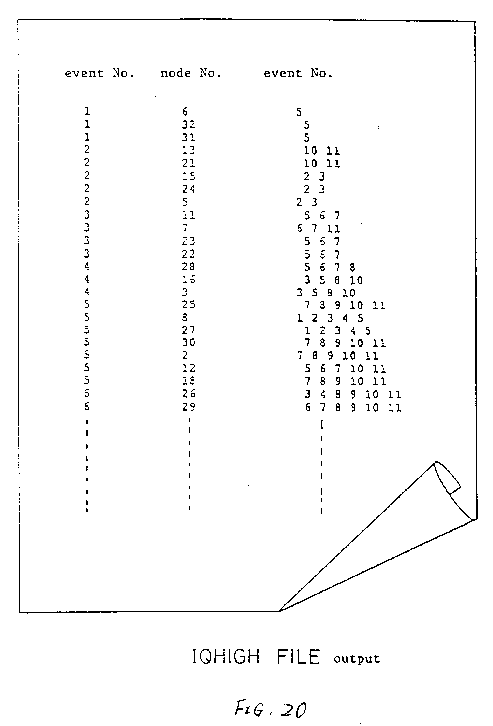

Step ST72: The 0-state file F12 and the 1-state file F13 outputted in Step ST71 are sorted using the number of events as a key. It facilitates to retrieve the nodes whose state is less changed by the test pattern applied in the simulation. The 0-state file F12 sorted is outputted to the 0-state sorted file (IQLOW) F14 and the 1-state file F13 is outputted to the 1-state sorted file (IQHIGH) F15. A part of each file output is shown in Figs. 19 and 20.

As seen from Figs. 19 and 20, the result sorted by the number of events facilitates to retrieve a minimum required test pattern for turning the state of the node into 0 or 1. Noticing on ones that turn the node state into 0, the node No. 6 turns into 0 state only in the event by the test pattern No. 4, so that IQ needs to be measured by the test pattern No. 4. That is, the node No. 6 is the node that has a least possibility to turn into observable state and the test pattern that controls and turns this node into observable state is the test pattern No. 4.

Step ST73: A minimum required test pattern for turning the state of each node into 0 and 1 is selected from patterns that can control and turn the state of nodes having low frequency to turn into observable state

from the sorted 0-state file F14 and the 1-state file F15 to create an an IQ test pattern group.

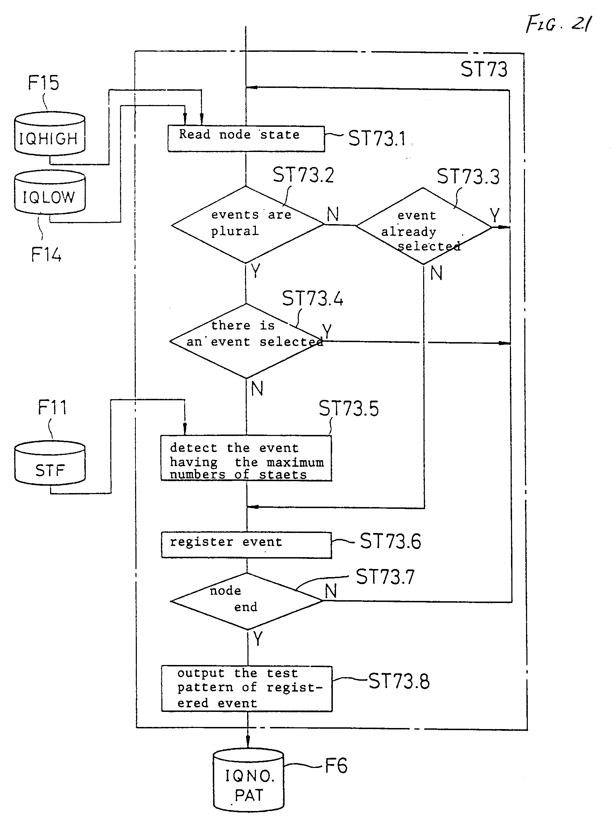

Fig. 21 shows the detail flow chart of this step. At first, data is read from the nodes having less number of events from the 0-state file F14 or 1-state file F15 (ST73.1). For example, the node state is read from the head of the F15 shown in Fig. 20, here.

Whether a plurality of events is listed up is judged (ST73.2). If it is not plural, the state of that node can be realized only in that event, so the event is registered in Step ST73.1. However, if it is an event already selected, it is not registered and the next node state is read (ST73.3). That is, in the 1-state file F15 in Fig. 20, the event No. 5 is registered and the processing till the node No. 31 is finished.

If a plurality of events is listed up, it is retrieved whether an event already registered exists or not among those events and if there is an event already registered, the step returns to read the next node state (ST73.4). It is because the state of the node can be realized in the event registered.

When no event registered is found among the events listed up, the frequency file F11 is referred and an event having a maximum number of nodes that can realize the state by the event is selected (ST73.5). It is because the number of states of nodes that can be realized in the same time can be maximized by selecting the event having the maximum number of nodes whose state change, so that the number of events to be selected can be reduced. In the 1-state file F15 shown in Fig. 20, the events that turn the node No. 13 into 1 state are Nos. 10 and 11. Referring now to the frequency file shown in Fig. 16, the number of nodes of state realizable is 29 in total in the event No. 10 and 25 in total in the event No. 11. Accordingly, the event No. 10 is selected.

Such operation is carried out for all the nodes in the file (ST73.7). Therefore, the events in which the state of each node is realized are registered as shown in Table 3, and the test pattern group that realized those events is outputted to the node control pattern file (IQNO, PAT) F6 (ST73.8).

Table 3

Event No.

| | | | | | |
|---|---|---|---|---|---|
| 3 | 4 | 5 | 7 | 10 | ... |

An IQ test pattern group minimum required for turning each node into 0 and 1 can be selected by the aforementioned flow. Accordingly, when there is a fault in the semiconductor device, the internal elements can be controlled and turned into observable state by applying the test pattern group to the semiconductor device. The quality of the semiconductor device can be thereby judged by measuring IQ of the semiconductor device to which each test pattern is applied.

Beside the method for retrieving events in which nodes having low frequency to turn into observable state are controlled and turned into observable state as described above, there is another method that notices on that each node is in observable state of 0 or 1 in any of the events and retrieves events which are in observable state other than the state of node in that event. That is, it is possible to select any event, eliminate observable states of the nodes in the event from other events and select events from ones having more numbers of observable states of the node from the events left. Then, an IQ test pattern group that allows to effectively measure IQ may be created by the test patterns that correspond to the event.

[System for Creating Test Patterns based on Off-leak of Transistors that Comprise Internal Elements]

A system for creating test patterns noticing on a specific state in which the static current IQ flows when there is an off-leak in transistors that comprise internal elements as described based on Table 2 is explained below.

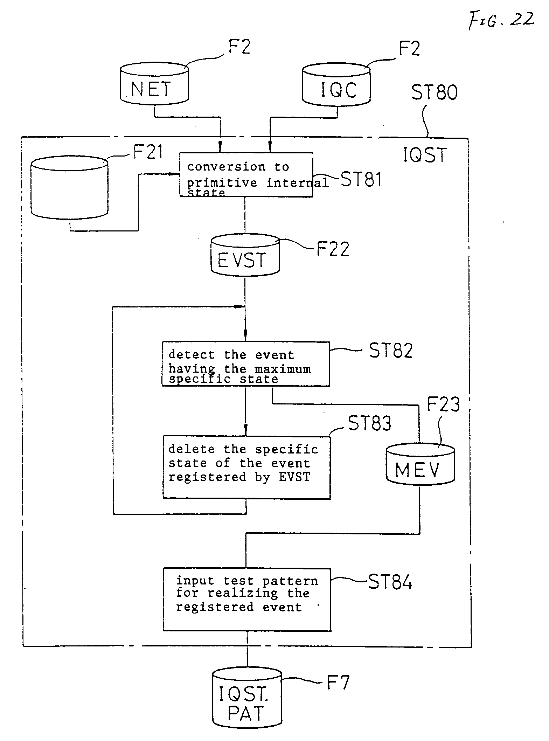

This system is a system that forms Step ST80 described in reference to Fig. 13 and the flow of the processes in the system is shown in Fig. 22. The content of each step is explained below.

Step ST81: State of each primitive (internal element) in each event is determined from the node state memory file F3 and the delay file F2 in which simulation models are stored based on the internal state information library F21 and it is in any specific states in which the off-leak can be detected, the specific states are listed up and are outputted to a primitive internal state file (EVST) F22 for every each event.

When there is an off-leak, observable states in which it can be detected are several specific states which are combinations of ON and OFF of the transistors as shown in Table 2.

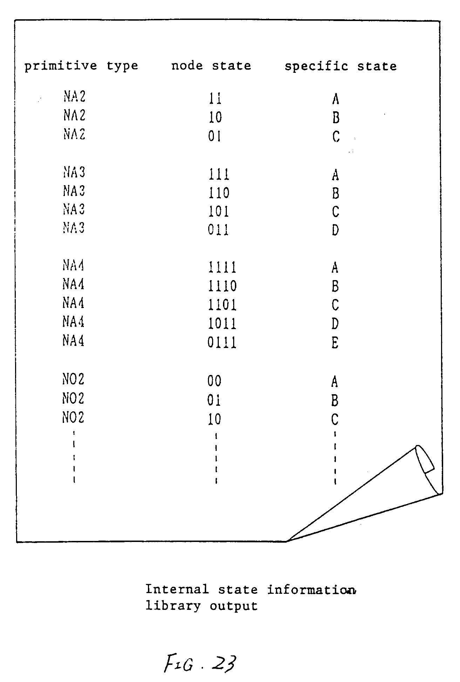

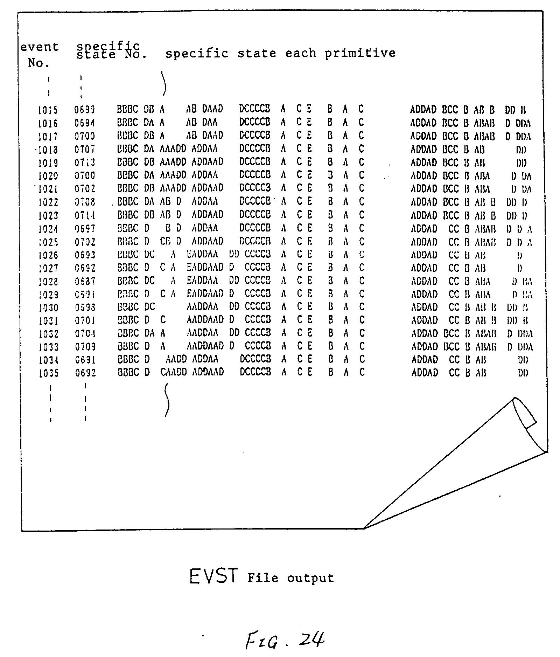

In the internal state information library F21, primitive types like 2-input NAND (NA2) and 2-input NOR (NO2) which are recognized as the minimum unit in simulation models, a part of whose output being shown in Fig. 23, and the specific states that correspond to each type of node state as shown in Table 2 are stored. Accordingly, the use of the library F21 enables to specify the states of primitives in each event from the delay file F2 which is a simulation model and from the node state memory file F3 in which the state of each node in each event is stored, as shown in Fig. 24.

Fig. 24 shows a part of the file output of a primitive internal state file (EVST) F22. In the file F22, event Nos., the number of primitives which are in specific state which is observable state in the event and the specific state of each primitive in alphabet are outputted in the order of primitives. When the state of the primitive does not suite for detecting the off-leak of the transistors that comprise the primitive, i.e. not in observable state, the state is not outputted and a blank is left.

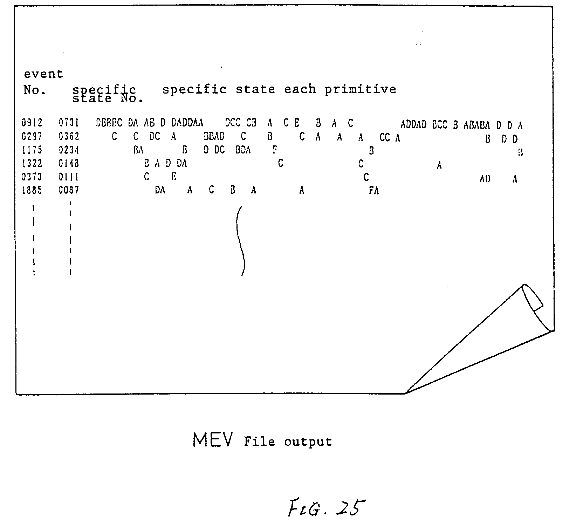

Step ST82: An event in which the number of primitives which are in observable state is maximum is retrieved from the primitive internal state file F22 outputted in Step ST81. Then the event is outputted to a maximum event file (MEV) F23 a part of whose file output is shown in Fig. 25. In the inspection by means of IQ, even if off-leaks occur in a plurality of primitives in the same time, the off-leaks can be detected as they exist by detecting IQ. Due to that, the inspection can be carried out effectively by measuring IQ in events in which as many as possible primitives are controlled and turned into observable state.

Step ST83: The observable state of the primitives controlled in the events retrieved in Step ST82 is erased from the specific states listed up in the events left. Then the step returns to Step ST82 to retrieve an event in which the number of observable states of the primitives left without having been erased is largest in the events left. Thus the events in which each primitive is controlled and turned into each observable state is selected.

For example, among events shown in Fig. 24, when an event No. 912 shown in Fig. 25 is selected in the event No. 1015, the observable states in the primitives left are as in Table 4 below.

Table 4

| Event No. | Number of Specific State | Specific State for Every Primitive |
|---|---|---|
| 1015 | 0699 | BBBC DB A AB DAAD DCCCCCB A C E ... |
| ↓ | | |
| 1015 | 0072 | B B D C ... |

As shown in Table 4, after selecting events in which the number of observable states is maximum, the observable states related to the selected events are erased from the events left and events in which the number of observable state left is maximum are selected in order.

Step ST84: The off-leak can be effectively detected by measuring IQ in the events selected in Step ST83. Accordingly, it is effective to inspect using the test pattern group that can control into the selected events as IQ test pattern groups. The test pattern group that corresponds to the events are outputted to the transistor control pattern file (IQST. PAT).

The system for creating test patterns that operates in accordance to the aforementioned flow allows to create the IQ test pattern group that allow to effectively detect faults accompanying to off-leaks. Although the test pattern group is outputted noticing on the events having numbers of internal elements controlled and turned into observable states in this example, the system may be one that retrieves events minimum required for realizing the observable state noticing on the observable state of each primitive and outputs the test pattern group related to the events, similarly to the system for creating test patterns noticing on node states as described before. That is, events controlled and turned into observable state are retrieved for every observable state of the primitives from the primitive internal state file F22 shown in Fig. 22. The IQ test pattern group may be created by selecting primitives having less frequency to turn into observable state from the test patterns that can control and turn into the observable state from the retrieval result. The use of the IQ test pattern group allows to effectively carry out the inspection.

The structure of the systems for creating test patterns noticing on node states and on off-leaks may be same with the system explained before based on Fig. 12. Moreover, those systems for creating test patterns may be realized using the CPU 26 and the memory 27 of the inspecting system explained based on Fig. 7.

Furthermore, the above description has been made on the inspection in which no restriction need to be added to node states. That is, when the semiconductor device or a circuit within the semiconductor device to be inspected is all comprised of complementary MISFETs like CMOS, normal current does not flow in a state in which the internal elements are stable. Due to that, IQ may be measured even if the node state is either 0 or 1. However, in a device containing a resistor for pull-up or a MOS, IQ cannot be detected in a state in which current flows in the resistor and others, since normal current flows in the power circuit. Therefore, IQ has to be measured in a state in which no current flows in the pull-up resistor or MOS in the inspection of such device. Such a state may be extracted by retrieving events in which a specific node is 0 or 1 from the node state memory file in which results of simulations are stored. Then it is possible to create a test pattern group suited for the inspection using IQ by the several systems described above based on the extracted events. It is also possible to determine the quality of those elements based on IQ measured in a state in which no current flows in the pull-up resistor or the MOS. Thus, by adding several restrictions in retrieving the node state or the internal state of the primitives in the systems for creating test patterns, the inspection method and the system based on the measurement of IQ described above may be used for inspection of not only complementary semiconductor devices but also various semiconductor devices.

Although the system for selecting an IQ test pattern group from registered test pattern group or automatically generated test pattern group have been explained above, the system may be one that creates the IQ test pattern group from test patterns generated by input values which have been adjusted so that a certain node state or a certain internal state of primitives is turned into observable state. This system requires no observation of faults at the output side, differing from the conventional system for creating test patterns, so that it aims at generating test patterns that can control and turn the node state or the internal state of the primitives into observable state, not test patterns that mainly aim at propagating faults. Because of that, the time necessary for generating the test pattern group may be shortened. Then the inspection based on the static current using this test pattern group allows the same functional inspection as in the past and in the same time, allows to effectively carry out the inspection of faults that involve a long range reliability. As a matter of course, an IQ test pattern group whose inspection efficiency is improved further may be created by retrieving and selecting test patterns more suited for the measurement of IQ as described above based on the test pattern group which are created by the above systems for creating test patterns and whose input values are adjusted.

Accordingly, the inspection method and the system based on the measurement of the static current IQ of the present invention may be used for periodic inspection and fault diagnosis of semiconductor devices and complementary semiconductor devices in particular. Moreover, they can be also used for inspecting products in the production process of semiconductor devices. Furthermore, the inspection method and the system based on the static current of the present invention allows to effectively detect not only functional faults of the semiconductor device, but also defects involving a long range reliability, so that they are suited for inspection used for producing devices which require high reliability. Then, the systems for creating test patterns used for the inspection is useful for facilitating test designing of semiconductor devices.

**Claims**

18

**EP 0 494 311 A1**

1. A method for inspecting a semiconductor device at least having a functional cell provided with a plurality of internal elements including MISFET, said method comprising and at least repeating steps of:

controlling a state in which patterns selected in order from a static current inspecting pattern group that controls and turns state of each said internal element into observable state in which said static current flows due to a fault, are applied to said functional cell;

detecting said static current which is a very weak current that flows in a power circuit of said functional cell after said patterns being applied thereto; and

comparing said static current with a specified value.

2. A method for inspecting a semiconductor device at least having a functional cell provided with a plurality of internal elements including MISFET, said method comprising and at least repeating steps of:

controlling a state in which patterns selected in order from an inspecting pattern group that drives at least one said internal element are applied to said functional cell;

discriminating whether said patterns are those included in a static current inspecting pattern group that controls and turns state of each said internal elements into observable state in which said static current flows due to a fault;

detecting said static current which is a very weak current that flows in a power circuit of said functional cell after said patterns included in said static current detecting patterns being applied thereto; and

comparing said static current with a specified value.

3. The method for inspecting a semiconductor device according to Claim 1 or 2, wherein said static current inspecting pattern group is an input value adjusted pattern group whose input value is adjusted so that at least one said internal element can be controlled and turned into said observable state based on circuit information of said functional cell.

4. The method for inspecting a semiconductor device according to Claim 1 or 2, wherein said static current inspecting pattern group is a retrieved pattern group extracted from patterns included in said inspecting pattern group that can drive at least one said internal element based on the state of said internal element controlled by said patterns.

5. The method for inspecting a semiconductor device according to Claim 4, wherein said retrieved pattern group is a first optimized inspecting pattern group which is extracted in order from patterns that can drive said internal element having less frequency to turn into said observable state among patterns included in said inspecting pattern group.

6. The method for inspecting a semiconductor device according to Claim 4, wherein said retrieved pattern group is a second optimized inspecting pattern group extracted in order from patterns containing more numbers of said internal elements that turn into said observable state among patterns included in said inspecting pattern group.

7. The method for inspecting a semiconductor device according to Claim 1 or 6, wherein said static current inspecting pattern group is a node control pattern group that controls nodes which are connecting points for connecting said internal elements and said observable state is judged by the state of said nodes.

8. The method for inspecting a semiconductor device according to Claim 1 or 6, wherein said static current inspecting pattern group is a transistor control pattern group that controls ON and OFF of MISFETs that comprise said internal elements and said observable state is judged by a specific state of ON/OFF of said MISFETs that comprise said internal elements.

9. The method for inspecting a semiconductor device according to Claim 1 or 6, wherein said static current inspecting pattern group is a control pattern group comprised of patterns contained either in said node control pattern group that controls said nodes which are connecting points for connecting said internal elements or said transistor control pattern group that controls ON/OFF of said MISFETs that comprise said internal elements and said observable state is judged either by the state of said node or by the specific state of ON/OFF of said MISFETs that comprise said internal elements.

19

**10.** The method for producing a semiconductor device at least having an inspection process for inspecting said semiconductor device in accordance to said method for inspecting a semiconductor device described in Claim 1 or 9.

**11.** A system for inspecting a semiconductor device at least having a functional cell provided with a plurality of internal elements including MISFET, said system at least comprising:

internal element controlling means for controlling said internal elements based on patterns selected in order from a static current inspecting pattern group that controls and turns state of each said internal element into observable state in which said static current flows due to a fault; and

static current comparing means for comparing said static current which is a very weak current that flows in a power circuit of said functional cell controlled by said state controlling means with a specified value.

**12.** A system for inspecting a semiconductor device at least having a functional cell provided with a plurality of internal elements including MISFET, said system at least comprising:

internal element driving means for driving said internal elements based on patterns selected in order from an inspecting pattern group that drives at least one said internal element;

pattern discriminating means for determining whether said patterns are those included in a static current inspecting pattern group that controls and turns state of each said internal elements into observable state in which said static current flows due to a fault; and

static current comparing means for comparing said static current which is a very weak current that flows in a power circuit of said functional cell with a specified value after said patterns included in said static current inspecting pattern group are applied.

**13.** The system for inspecting a semiconductor device according to Claim 11 or 12, wherein said staic current comparing means for is provided with a voltage follower circuit connected to a power circuit of said functional cell and a discriminating circuit that determines said static current based on a difference of voltage between an input voltage and an output voltage of an operational amplifier used in said voltage follower circuit.

**14.** The system for inspecting a semiconductor device according to Claim 11 or 13, wherein said static current inspecting pattern group is an input value adjusted pattern group whose input value is adjusted so that at least one said internal element can be controlled and turned into said observable state based on circuit information of said functional cell.

**15.** The system for inspecting a semiconductor device according to Claim 11 or 13, wherein said static current inspecting pattern group is a retrieved pattern group extracted from patterns included in an inspecting pattern group that can drive at least one said internal element based on the state of said internal element controlled by said patterns.

**16.** The system for inspecting a semiconductor device according to Claim 15, wherein said retrieved pattern group is a first optimized inspecting pattern group which is extracted in order from patterns that can drive said internal element having less frequency to turn into said observable state among patterns included in said inspecting pattern group.

**17.** The system for inspecting a semiconductor device according to Claim 15, wherein said retrieved pattern group is a second optimized inspecting pattern group extracted in order from patterns containing more numbers of said internal elements that turn into said observable state among patterns included in said inspecting pattern group.

**18.** The system for inspecting a semiconductor device according to Claim 11 or 17, wherein said static current inspecting pattern group is a node control pattern group that controls nodes which are connecting points for connecting said internal elements and said observable state is judged by the state of said nodes.

**19.** The system for inspecting a semiconductor device according to Claim 11 or 17, wherein said static current inspecting pattern group is a transistor control pattern group that controls ON and OFF of MISFETs that comprise said internal elements and said observable state is judged by a specific state of ON/OFF of said MISFETs that comprise said internal elements.

20. The system for inspecting a semiconductor device according to Claim 11 or 17, wherein said static current inspecting pattern group is a control pattern group comprised of patterns contained either said node control pattern group that controls said nodes which are connecting points for connecting said internal elements or said transistor control pattern group that controls ON/OFF of said MISFETs that comprise said internal elements and said observable state is judged either by the state of said node or by the specific state of ON/OFF of said MISFETs that comprise said internal elements.

21. A system for creating a static current inspecting pattern group that controls and turns state of each said internal element into observable state in which the static current flows due to a fault in inspection of a semiconductor device at least having a functional cell provided with a plurality of said internal elements including MISFET, said system at least comprising input value adjusting means for forming an input value adjusted pattern group by input values that can control and turn at least one said internal element into said observable state and that are adjusted based on circuit information of said functional cell and on said observable state of said internal element.

22. A system for creating a static current inspecting pattern group that controls and turns state of each said internal element into observable state in which the static current flows due to a fault in inspection of a semiconductor device at least having a functional cell provided with a plurality of said internal elements including MISFET, said system at least comprising:
    simulation means for logically simulating based on an inspecting pattern group that drives at least one said internal element modeling said functional cell and said internal element registered;
    element state memorizing means for memorizing each element state of said internal element controlled by patterns included in said inspecting patterns obtained from said logical simulation; and
    pattern retrieving means that retrieves patterns that can control and turn said internal element into said observable state in which said static current flows due to a fault and that creates said static current inspecting pattern group.

23. The system for creating test patterns according to Claim 22, wherein said pattern retrieving means is a first optimized retrieving means that creates said static current inspecting pattern group by extracting in order from patterns that turn said internal element having less frequency to turn into said observable state into observable state from said inspecting pattern group.

24. The system for creating test patterns according to Claim 23, wherein said optimized retrieving means is provided with low-drive internal element retrieving means for retrieving low-drive internal elements which are internal elements having less frequency to turn into from said element state to said observable state and first optimized pattern extracting means that creates said static current inspecting patterns extracting in order from patterns that turn said low-drive internal elements into said observable state from said inspecting pattern group.

25. The system for creating test patterns according to Claim 22, wherein said pattern retrieving means is a second optimized retrieving means that creates said static current inspecting pattern group by extracting in order from patterns that contain many said element states controlled into and turned said observable state.

26. The system for creating test patterns according to Claim 25, wherein said second optimized retrieving means is provided with said second optimized pattern extracting means that extracts patterns which contain many said element states controlled and turned into said observable state and element state reducing means that erases said observable states realized by patterns extracted from said element states and updates said element state.

27. The system for creating test patterns according to Claim 21 or 26, wherein said static current inspecting pattern group is a node control pattern group that controls nodes which are connecting points for connecting said internal elements and said observable state is judged by the state of said nodes.

28. The system for creating test patterns according to Claim 21 or 26, wherein said static current inspecting pattern group is a transistor control pattern group that controls ON and OFF of MISFETs that comprise said internal elements and said observable state is judged by a specific state of ON/OFF of said MISFETs that comprise said internal elements.

29. The system for creating test patterns according to Claim 21 or 26, wherein said static current inspecting pattern group is a control pattern group comprised of patterns contained either said node control pattern group that controls said nodes which are connecting points for connecting said internal elements or said transistor control pattern group that controls ON/OFF of said MISFETs that comprise said internal elements and said observable state is judged either by the state of said node or by the specific state of ON/OFF of said MISFETs that comprise said internal elements.

FIG. 1

NAND

(a)

FIG. 2

(b)

FIG. 3

(a)        (b)

FIG. 4

(a)    (b)

FIG. 5

(a)    (b)

FIG. 6

*Fig. 7*

$F_{IG}.\ 8$

FIG. 9

```
                    ┌──────────────┐
                    │    START     │
                    └──────┬───────┘
                           │
            ┌──────────────┴──────────────┐
            │ Register/Correct            │────── ST21
            │ logical circuit             │
            └──────────────┬──────────────┘
   ┌─────────────────────► │
   │        ┌──────────────┴──────────────┐
   │        │ Register/Correct            │────── ST22
   │        │ test patterns               │
   │        └──────────────┬──────────────┘
   │                       │
   │        ┌──────────────┴──────────────┐
   │        │ fault simulation            │────── ST23
   │        └──────────────┬──────────────┘
   │                       │
   │       N           ╱───┴───╲
   └──────────────────< The rate  >────── ST24
                        ╲ of fault ╱
                         ╲simulation OK╱
                             │ Y
            ┌────────────────┴────────────────┐
            │ Output of test pattern group    │────── ST25
            └────────────────┬────────────────┘
                             │
                    ┌────────┴────────┐
                    │      END        │
                    └─────────────────┘
```

FIG. 10

```
                              ┌──────────────┐ ST31
                              │ test pattern │
                              └──────┬───────┘
          ┌──────────────────┬──────┴──────────────────┐
          │                  │                          │
    ┌─────▼──────────┐ ST32  │              ┌───────────▼─────┐
    │ expexted value │       │      ST33 ─  │ output by       │
    │ by a normal    │       │              │ fault list      │
    │ circuit        │       │              └─────────┬───────┘
    └───────┬────────┘       │                        │
            │                │                        │
            │           ┌────▼─────────┐ ST35    ┌────▼──────────┐
      ST34  │           │  expexted    │   Y     │ eliminate     │
            └──────────▶│  value       ├────────▶│ fault from    │
                        │  = output    │         │ the fault     │
                        └──────┬───────┘         │ list          │
                               │ N               └───────┬───────┘
                               │◀────────────────────────┘
                        ┌──────▼───────┐
                  ST36  │  fault       │    N
                        │  list end    ├──────────────────────▶
                        └──────┬───────┘
                               │
                        ┌──────▼───────┐ ST37        ST38
                  ST37  │  fault       │   Y    ┌─────────────────────┐
                        │  is          ├───────▶│ register test       │
                        │  detectable  │        │ pattern             │
                        └──────┬───────┘        └──────────┬──────────┘
                               │ N                         │
                               │◀──────────────────────────┘
```

FIG. 11

```
                ┌──────────────┐
                │    START     │
                └──────────────┘
                       │
          ┌─────────────────────────┐
          │ register/correct        │───ST41
          │ logic circuit           │
          └─────────────────────────┘
                       │
      ┌────────────────┤
      │   ┌─────────────────────────┐
      │   │ register/correct        │───ST42
      │   │ test pattern            │
      │   └─────────────────────────┘
      │                │
      │   ┌─────────────────────────┐
      │   │ logical simulation      │───ST43
      │   └─────────────────────────┘
      │                │
      │   ┌─────────────────────────┐
      │   │ detect the state of     │───ST44
      │   │ the internal element    │
      │   └─────────────────────────┘
      │                │
      │              ╱────╲
      │            ╱ the     ╲          ST45
      └──────────╱ amount of obser ╲
                  ╲ vable states   ╱ OK
                    ╲            ╱
                      ╲────────╱
                          │
          ┌─────────────────────────┐
          │ IO  test pattern group  │───ST46
          │     output              │
          └─────────────────────────┘
                       │
                ┌──────────────┐
                │     END      │
                └──────────────┘
```

FIG. 12

inspecting system

FIG. 13

FIG. 14

```
event    node state (node numbers & states)

   :
   :
101    8 1 9 0 13 0 14 1 15 0 16 0 17 0 21 2 24 0 25 0 27 1
102    5 1 9 1 15 1 24 1
103    3 1 7 0 10 1 11 0 12 0 16 1 20 1 22 0 23 0 26 1
104    3 0 5 0 6 0 9 0 15 0 16 0 18 0 24 0 28 0 31 0 32 0
105    3 1 6 1 10 0 11 1 12 1 16 1 20 0 22 1 23 1 26 0 28
106    3 0 4 1 6 2 7 1 8 0 16 0 17 1 27 0 29 1 31 0 32 0
107    2 1 9 1 18 1 25 1 30 1
108    3 1 7 0 10 1 11 0 12 0 16 1 20 1 22 0 23 0 26 1
109    3 0 15 0 28 0
110    1 0 3 1 12 1 13 1 14 0 16 1 21 1
111    3 0 7 1 16 0
   :        ↑ ↑  state of changed node
   :
        node number
```

IQC File output

*FIG. 15*

35

| event | node to be "0" state | node to be "1" state |
|---|---|---|
| 1 | 4 | 13 |
| 2 | 8 | 9 |
| 3 | 13 | 12 |
| 4 | 7 | 23 |
| 5 | 14 | 16 |
| 6 | 11 | 18 |
| 7 | 16 | 13 |
| 8 | 16 | 13 |
| 9 | 13 | 16 |
| 10 | 16 | 13 |
| 11 | 15 | 10 |

STF File output

FIG. 16

```
event No.    node No.    event No.

    2            1        10 11
    7            2        0  1  2  3  4  5  6
    8            3        0  1  2  4  6  7  9  11
    5            4        0  1  2  3  4  5
   10            5          0  1  4  5  6  7  8  9  10 11
    :            6        4
    5            7        3  4  5  8  9  10
    5            8        5  7  8  9  10 11
    4            9        1  4  5  6
    3           10          5  6  7
    6           11        3  4  8  9  10 11
    4           12        3  4  8  9
    9           13        1  2  3  4  5  6  7  8  9
    2           14        10 11
    9           15        1  4  5  6  7  8  9  10 11
    7           16        1  2  4  6  7  9  11
    5           17        1  2  3  4  5
    3           18        4  5  6
    :            :          :
    :            :          :
    :            :          :
    :            :          :
    :            :          :
```

IQL  File output

F₁G. 17

```
event No.        node No.        event No.

    10               1            0  1  2  3  4  5  6  7  8  9
     5               2            7  8  9  10 11
     4               3            3  5  8  10
     6               4            6  7  8  9  10 11
     2               5            2  3
     1               6            5
     3               7            6  7  11
     5               8            1  2  3  4  5
     7               9            2  3  7  8  9  10 11
     6               10            3  4  8  9  10 11
     3               11            5  6  7
     5               12            5  6  7  10 11
     2               13           10 11
     9               14           1  2  3  4  5  6  7  8  9
     2               15            2  3
     4               16            3  5  8  10
     6               17            6  7  8  9  10 11
     5               18            7  8  9  10 11
     ¦               ¦             ¦
     ¦               ¦             ¦
     ¦               ¦             ¦
     ¦               ¦             ¦
     ¦               ¦             ¦
```

IQH File output

FIG. 18

38

| event No. | node No. | event No. |
|---|---|---|
| 1 | 6 | 4 |
| 2 | 1 | 10 11 |
| 2 | 14 | 10 11 |
| 3 | 10 | 5 6 7 |
| 3 | 18 | 4 5 6 |
| 3 | 26 | 5 6 7 |
| 3 | 20 | 5 6 7 |
| 4 | 12 | 3 4 8 9 |
| 4 | 28 | 4 9 10 11 |
| 4 | 9 | 1 4 5 6 |
| 4 | 23 | 3 4 8 9 |
| 5 | 17 | 1 2 3 4 5 |
| 5 | 29 | 1 2 3 4 5 |
| 6 | 25 | 1 2 3 4 5 6 |
| 6 | 4 | 0 1 2 3 4 5 |
| 6 | 22 | 3 4 8 9 10 11 |
| 6 | 7 | 3 4 5 8 9 10 |
| 6 | 27 | 6 7 8 9 10 11 |
| 6 | 11 | 3 4 8 9 10 11 |
| 6 | 8 | 6 7 8 9 10 11 |
| 7 | 32 | 4 6 7 8 9 10 11 |
| 7 | 30 | 0 1 2 3 4 5 6 |
| 7 | 31 | 4 6 7 8 9 10 11 |
| 7 | 16 | 1 2 4 6 7 9 11 |
| 7 | 2 | 0 1 2 3 4 5 6 |
| 8 | 3 | 0 1 2 4 6 7 9 11 |
| 9 | 13 | 1 2 3 4 5 6 7 8 9 |
| 9 | 24 | 1 4 5 6 7 8 9 10 11 |
| 9 | 15 | 1 4 5 6 7 8 9 10 11 |
| 10 | 5 | 0 1 4 5 6 7 8 9 10 11 |
| ¦ | ¦ | ¦ |
| ¦ | ¦ | ¦ |
| ¦ | ¦ | ¦ |
| ¦ | ¦ | ¦ |
| ¦ | ¦ | ¦ |

IQLOW FILE output

FIG. 19

```
event No.    node No.     event No.

    1            6         5
    1           32          5
    1           31          5
    2           13          10 11
    2           21          10 11
    2           15          2 3
    2           24          2 3
    2            5         2 3
    3           11           5 6 7
    3            7         6 7 11
    3           23           5 6 7
    3           22           5 6 7
    4           28           5 6 7 8
    4           16           3 5 8 10
    4            3         3 5 8 10
    5           25            7 8 9 10 11
    5            8         1 2 3 4 5
    5           27            1 2 3 4 5
    5           30            7 8 9 10 11
    5            2         7 8 9 10 11
    5           12            5 6 7 10 11
    5           18            7 8 9 10 11
    6           26            3 4 8 9 10 11
    6           29            6 7 8 9 10 11
```

IQHIGH FILE output

FiG. 20

FIG. 21

ST73

F15

IQHIGH

IQLOW

F14

Read node state —— ST73.1

ST73.2                    ST73.3

events are — N — event already selected — Y

plural                    N

Y

ST73.4

there is an event selected — Y

N

F11

STF

detect the event having the maximum numbers of staets — ST73.5

register event —— ST73.6

node end — N — ST73.7

Y

output the test pattern of registered event —— ST73.8

IQNO. PAT —— F6

FIG. 22

| primitive type | node state | specific state |
|---|---|---|
| NA2 | 11 | A |
| NA2 | 10 | B |
| NA2 | 01 | C |
| NA3 | 111 | A |
| NA3 | 110 | B |
| NA3 | 101 | C |
| NA3 | 011 | D |
| NA4 | 1111 | A |
| NA4 | 1110 | B |
| NA4 | 1101 | C |
| NA4 | 1011 | D |
| NA4 | 0111 | E |
| NO2 | 00 | A |
| NO2 | 01 | B |
| NO2 | 10 | C |

Internal state information
library output

FIG. 23

```
event   specific
No.     state No.   specific state each primitive

   ¦       ¦              )
   ¦       ¦
  1015    0699    BBBC DB A    AB DAAD    DCCCCB  A  C E   B  A  C       ADDAD BCC B AB B   DD B
  1016    0694    BBBC DA A    AB DAA     DCCCCB  A  C E   B  A  C       ADDAD BCC B ABAB   D DDA
  1017    0700    BBBC DB A    AB DAAD    DCCCCB  A  C E   B  A  C       ADDAD BCC B ABAB   D DDA
  1018    0707    BBBC DA AAADD ADDAA     DCCCCB  A  C E   B  A  C       ADDAD BCC B AB     DD
  1019    0713    BBBC DB AAADD ADDAAD    DCCCCB  A  C E   B  A  C       ADDAD BCC B AB     DD
  1020    0700    BBBC DA AAADD ADDAA     DCCCCB  A  C E   B  A  C       ADDAD BCC B ABA    D DA
  1021    0702    BBBC DB AAADD ADDAAD    DCCCCB  A  C E   B  A  C       ADDAD BCC B ABA    D DA
  1022    0708  . BBBC DA AB D  ADDAA     DCCCCB  A  C E   B  A  C       ADDAD BCC B AB B   DD D
  1023    0714    BBBC DB AB D  ADDAAD    DCCCCB  A  C E   B  A  C       ADDAD BCC B AB B   DD D
  1024    0697    BBBC D   B D  ADDAA     DCCCCB  A  C E   B  A  C       ADDAD  CC B ABAB   D D A
  1025    0702    BBBC D   CB D ADDAAD    DCCCCB  A  C E   B  A  C       ADDAD  CC B ABAB   D D A
  1026    0693    BBBC DC    A  EADDAA  DD CCCCB   A  C E   B  A  C       ADDAD  CC B AB      D
  1027    0692    BBBC D  C A  EADDAAD D  CCCCB   A  C E   B  A  C       ADDAD  CC B AB      D
  1028    0687    BBBC DC    A  EADDAA  DD CCCCB   A  C E   B  A  C       ADDAD  CC B ABA    D EA
  1029    0691    BBBC D  C A  EADDAAD D  CCCCB   A  C E   B  A  C       ADDAD  CC B ABA    D EA
  1030    0698    BBBC DC       AADDAA  DD CCCCB   A  C E   B  A  C       ADDAD  CC B AB B   DD B
  1031    0701    BBBC D  C     AADDAAD D  CCCCB   A  C E   B  A  C       ADDAD  CC B AB B   DD B
  1032    0704    BBBC DA A     AADDAA  DD CCCCB   A  C E   B  A  C       ADDAD BCC B ABAB   D DDA
  1033    0709    BBBC D  A     AADDAAD D  CCCCB   A  C E   B  A  C       ADDAD BCC B ABAB   D DDA
  1034    0691    BBBC D   AADD ADDAA     DCCCCB  A  C E   B  A  C       ADDAD  CC B AB     DD
  1035    0692    BBBC D   CAADD ADDAAD    DCCCCB  A  C E   B  A  C       ADDAD  CC B AB     DD
   ¦       ¦
   ¦       ¦              )
   ¦       ¦
```

EVST File output

FIG. 24

```
event
No.    specific   specific state each primitive
       state No.

0912   0731   DBBBC DA AB D DADDAA    DCC CB  A  C E   B   A  C          ADDAD BCC B ABABA D D A
0297   0362      C   C  DC  A     BBAD   C     B     C A   A   A   CC A              B  D D
1175   0234         BA       B   D DC  BDA    F                     B                       B
1322   0148       B A D DA                 C              C              A
0373   0111       C   E                                   C                   AD   A
1885   0087          DA   A   C  B   A        A           FA
```

MEV File output

FIG. 25

$F\imath G.26$

# INTERNATIONAL SEARCH REPORT

International Application No PCT/JP91/00971

**I. CLASSIFICATION OF SUBJECT MATTER (if several classification symbols apply, indicate all)** [6]

According to International Patent Classification (IPC) or to both National Classification and IPC

Int. Cl$^5$  G01R31/318, H01L21/66

**II. FIELDS SEARCHED**

| Minimum Documentation Searched [7] | |
|---|---|
| Classification System | Classification Symbols |
| IPC | G01R31/318, 31/26, 19/195, H01L21/66 |

Documentation Searched other than Minimum Documentation
to the Extent that such Documents are Included in the Fields Searched [8]

| | |
|---|---|
| Jitsuyo Shinan Koho | 1926 – 1991 |
| Kokai Jitsuyo Shinan Koho | 1971 – 1991 |

**III. DOCUMENTS CONSIDERED TO BE RELEVANT** [9]

| Category [*] | Citation of Document, [11] with Indication, where appropriate, of the relevant passages [12] | Relevant to Claim No. [13] |
|---|---|---|
| Y | JP, A, 55-166057 (Matsushita Electric Ind. Co., Ltd.), December 24, 1980 (24. 12. 80), (Family: none) | 1, 3, 8, 10, 11, 19 |
| Y | JP, A, 57-169684 (NEC Corp.), October 19, 1982 (19. 10. 82), (Family: none) | 1, 3, 8, 10, 11, 19 |
| T | JP, A, 3-78672 (Hitachi, Ltd. and another), April 3, 1991 (03. 04. 91), (Family: none) | 1, 3, 8, 10, 11, 19 |

[*] Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| October 9, 1991 (09. 10. 91) | October 28, 1991 (28. 10. 91) |
| International Searching Authority | Signature of Authorized Officer |
| Japanese Patent Office | |

Form PCT/ISA/210 (second sheet) (January 1985)